# EUROPÄISCHE PATENTSCHRIFT

(11) **EP 3 473 498 B1**
(45) Veröffentlichungstag und Bekanntmachung des Hinweises auf die Patenterteilung: **29.04.2020**
(21) Anmeldenummer: 18195842.2
(22) Anmeldetag: 21.09.2018
(51) Int. Cl.: B60R 13/02, B60R 13/04

(54) **FAHRZEUGVERKLEIDUNG MIT ANZEIGEFUNKTIONALITÄT**
VEHICLE CLADDING WITH DISPLAY FUNCTIONALITY
REVÊTEMENT DE VÉHICULE À FONCTIONNALITÉ D'AFFICHAGE

(30) Priorität: 17.10.2017 DE 102017218516
(43) Veröffentlichungstag der Anmeldung: 24.04.2019
(73) Patentinhaber: VOLKSWAGEN AKTIENGESELLSCHAFT, 38440 Wolfsburg (DE)
(72) Erfinder: Ette, Bernd, 38442 Wolfsburg (DE); Morgner, Andre, 08209 Auerbach (DE)

(56) Entgegenhaltungen:
- EP-A1- 3 150 442
- WO-A1-2017/055886
- DE-A1-102016 100 064
- US-A1- 2017 050 616

## Beschreibung

Die Erfindung betrifft eine Fahrzeugverkleidung mit Anzeigefunktionalität, insbesondere eine Fahrzeugverkleidung in Form einer Blende, besonders bevorzugt einer Blende für ein Kraftfahrzeug.

Aus der DE 10 2010 013 700 A1 ist eine Blende aus Kunststoff für ein Fahrzeug, insbesondere ein Kraftfahrzeug, bekannt, welche eine erste Komponente aus Kunststoff und eine zweite Komponente aus Kunststoff umfasst. Die erste Komponente ist zumindest teilweise transparent oder semitransparent. Die zweite Komponente weist eine oder mehrere Aussparungen für ein Anzeigeelement und/oder für ein Eingabeelement auf. Bei dem Eingabeelement kann es sich insbesondere um ein Tastenfeld handeln, dessen Tasten durch Fingerdruck betätigbar sind. Als Alternative ist ein Fingerabdrucksensor genannt.

Eine solche Blendeneinheit oder Fahrzeugverkleidung kann insbesondere an einer A-Säule, B-Säule oder C-Säule eines Fahrzeugs oder im Bereich einer Fahrzeugtür, insbesondere im Bereich einer Fahrzeugtür, die eine der genannten Fahrzeugsäulen überdeckt, angeordnet werden. Im Stand der Technik ist ferner beschrieben, dass das Anzeigeelement mit einem Keyless-Go-Sensor gekoppelt sein kann. Eine interaktive Erfassung von Nutzereingaben ist jedoch nur über eine berührende Betätigung bekannt. Dieses ist nachteilig, da hierdurch Fett- und Schmutzpartikel auf die Fahrzeugverkleidung übertragen werden, welches eine Anmutung der Fahrzeugverkleidung beeinträchtigt und zu dauerhaften Beschädigungen führen kann.

Darüber hinaus ist im Stand der Technik ein Schutz gegen Feuchtigkeit und andere Umwelteinflüsse, beispielsweise für die Leuchtmittel der Anzeigeeinheit, nicht befriedigend gelöst. Im Stand der Technik ist eine Einhausung beschrieben, die über eine umlaufende Polymerdichtung gegen eine Rückseite der Blende abgedichtet ist. Aufgrund von Temperaturänderungen, insbesondere verursacht durch direkter Sonneneinstrahlung auf die Fahrzeugverkleidung bzw. Blende, treten zwischen den unterschiedlichen Materialien Spannungen und/oder Versprödungen auf, die zu einer Undichtigkeit des Dichtmaterials führen können.

Aus der US 2009/0160529 A1 ist eine Touchsensoranordnung bekannt. Aus der DE 11 2013 005 176 T5 sind eine beleuchtete Verkleidungsbaugruppe und ein gelochtes Bauteil für die Verkleidungsbaugruppe bekannt. Aus der US 2017/0139506 A1 ist eine Fahrzeugsäulenanordnung mit einer Mensch-Fahrzeug-Schnittstelle bekannt. Aus der WO 2017/055886 A1 ist eine Eingabeeinrichtung für ein Fahrzeug bekannt.

Aus der US 2017/0050616 A1 ist ein schlüsselloses Zugangssystem mit einer Fahrzeugverkleidung nach dem Oberbegriff von Anspruch 1 bekannt. Dieses kann ein oder mehrere NFC-Geräte (Near Field Communication) enthalten. Ferner wird auch ein schlüsselloses Zugangssystem beschrieben, das ein NFC-Gerät und eine Tastatur umfasst. In einer besonderen Ausführungsform wird ein schlüsselloses Fahrzeugzugangssystem bereitgestellt, das in eine Fahrzeugverkleidungskomponente integriert ist. Einige Implementierungen umfassen eine Antenne, die von der Verkleidungskomponente getragen oder in diese eingebettet ist.

Aus der EP 3 150 442 A1 ist ein Zierteil für ein Fahrzeug bekannt, mit einer Trägerschicht und einer Deckschicht, die im Spritzgussverfahren aus thermoplastischem Kunststoff gebildet sind, mindestens einer Folie, die auf einer Oberflächenseite von der Deckschicht umspritzt und auf der gegenüberliegenden Oberflächenseite partiell von der Trägerschicht umspritzt ist, wobei die Trägerschicht im Bereich der bedruckten Folie zumindest eine Aussparung aufweist, in welcher eine Leuchteinheit zur Beleuchtung der Folie anordbar ist. Weiterhin ist ein Verfahren zur Herstellung eines Zierteils beschrieben.

Aus der WO 2017/055886 A1 ist eine Fahrzeugeinstiegsvorrichtung zur Ausstattung eines Fahrzeugs bekannt, mit einem Gehäuse, das einen Hohlraum definiert und an dem Fahrzeug befestigbar ist; und einem Elektronikmodul, das in dem Hohlraum angeordnet ist, umfassend eine Leiterplatte, eine Antenne, die mit der Leiterplatte verbunden und zum Erfassen eines NFC-Signals konfiguriert ist, wobei die Antenne Wicklungen umfasst, die direkt auf der Leiterplatte angeordnet sind, einen NFC-Empfänger, der mit der Leiterplatte in Kommunikation mit der Antenne steht und konfiguriert ist, um das NFC-Signal von der Antenne zu empfangen und ein Verarbeitungselement, das mit der Leiterplatte verbunden ist, in Kommunikation mit dem NFC-Empfänger und konfiguriert ist, um ein Steuersignal basierend auf dem NFC-Signal, das von dem NFC-Empfänger gesendet wird, an ein Steuersystem des Fahrzeugs bereitzustellen, wobei das Steuersignal den Zugang zum Fahrzeug ermöglicht. Ferner ist auch ein Fahrzeugverkleidungsbauteil beschrieben, das mit einer solchen Fahrzeugeinstiegsvorrichtung ausgestattet ist.

Aus der DE 10 2016 100 064 A1 ist ein Verfahren zur interaktiven Darstellung von Inhalten bekannt, an einer Außenfläche eines Fahrzeugs, wobei das Fahrzeug eine Erfassungseinrichtung und eine Anzeigeeinrichtung aufweist. Es sind Schritte vorgesehen, des Detektierens einer Annäherung einer Person an das Fahrzeug; des Schaltens der Anzeigeeinrichtung von einem ruhenden Zustand in einen aktiven Zustand bei einer detektierten Annäherung; des Erkennens von Gesten der Person; und des Veränderns der dargestellten Inhalte der Anzeigeeinrichtung in Abhängigkeit der Gesten.

Der Erfindung liegt die technische Aufgabe zugrunde, die aus dem Stand der Technik bekannten Verkleidungen für Fahrzeuge mit Anzeigefunktionalität zu verbessern und eine oder mehrere der genannten Nachteile zu beseitigen oder abzumildern.

Die technische Aufgabe wird durch eine Fahrzeugverkleidung mit den Merkmalen des Patentanspruchs 1 gelöst. Vorteilhafte Ausgestaltungen und Weiterbildungen ergeben sich aus den Unteransprüchen.

Insbesondere wird eine Fahrzeugverkleidung mit Anzeigefunktionalität geschaffen, welche eine Blendeneinheit mit mindestens einem im sichtbaren Wellenlängenbereich für eine Durchleuchtung transparenten Fensterabschnitt sowie eine Funktionseinheit mit mindestens einem Leuchtmittel und/oder einer Eingabeeinheit umfasst, wobei die Funktionseinheit als Grundmodul mit einem in sich abgeschlossenen, wasserdichten Gehäuse ausgebildet ist, in dessen Inneren das mindestens eine Leuchtmittel und/oder die Eingabeeinheit angeordnet sind. Ein Vorteil besteht darin, dass alle funktionalen Einheiten, welche elektrische oder elektronische Komponenten enthalten, in dem Grundmodul angeordnet sind, welches gegen Wasser abgedichtet ist. Vorzugsweise ist das Gehäuse aus einem Kunststoffmaterial, insbesondere einem thermoplastischen Kunststoffmaterial, gebildet und verschweißt.

Vorteil der Erfindung ist es, dass eine solche Fahrzeugverkleidung in Bereichen eingesetzt werden kann, bei denen die Blende selbst gegenüber anderen Fahrzeugteilen nicht komplett abgedichtet sein muss. Da die Fahrzeugverkleidung neben dem Grundmodul keine weiteren elektrischen oder elektronischen Funktionsbestandteile umfasst, müssen die übrigen Komponenten nicht wasserdicht ausgeführt sein.

Das ansonsten vollständig umschlossene und vorzugsweise lasergeschweißte Gehäuse kann, sofern im Inneren größere Hohlräume vorhanden sind, ein Luftaustauschelement umfassen, um im Innern Kondensation zu vermeiden. Ein Luftaustauschelement kann beispielsweise mit Hilfe einer Membran, beispielsweise aus expandiertem Polytetrafluorethylen (ePTFE), ausgebildet sein. Vorzugsweise wird das Grundmodul jedoch so aufgebaut, dass im Inneren keine odernahezu keine Hohlräume entstehen und das Gehäuse vollständig hermetisch über das Kunststoffmaterials des Gehäuses verschlossen und verschweißt werden kann.

Bei einer erfindungsgemäßen Ausführungsform ist zwischen der Blendeneinheit und dem Grundmodul ein Lichtleitmodul angeordnet, wobei das Lichtleitmodul mindestens eine Aussparung zum Ausbilden eines hinterleuchtbaren Informationsbereiches aufweist, wobei die mindestens eine Aussparung von dem Fensterbereich der Blendeneinheit überdeckt ist oder mit einem Teil des Fensterbereichs zusammenfällt, so dass in die Aussparung eingestrahltes Licht beim Hinterleuchten durch die Blendeneinheit hindurchtreten kann.

Die Information, die an einen Fahrzeugnutzer übermittelt wird, wird in der Regel durch ein Informationselement oder Symbolelement festgelegt, welches opake und transparente Bereiche umfasst und die Aussparung des Informationsbereichs abdeckt oder überdeckt, wobei die transparenten Bereiche eine hinterleuchtbare Information des Informationsbereichs der jeweiligen Aussparung festlegen. Sind mehrere Aussparungen in dem Lichtleitmodul ausgebildet, so sind diese optisch gegeneinander isoliert, d.h. Licht das zur Hinterleuchtung in eine Aussparung und somit einen Informationsbereich eingestrahlt wird, tritt nicht in andere Aussparungen oder Informationsbereiche ein.

Das Informationselement, welches auch Symbolelement genannt wird, da die Information häufig in Form eines Symbols dargestellt ist, kann auch beispielsweise an oder in dem Lichtleitmodul oder auch in der Blendeneinheit ausgebildet sein.

Vorzugsweise ist das Lichtleitmodul getrennt von der Blendeneinheit hergestellt und mit dieser verbunden. Beispielsweise ist das Lichtleitmodul mit der Blendeneinheit über eine Rastverbindung gekoppelt. Hierdurch wird eine Flexibilisierung erreicht, da eine zu vermittelnde Information und/oder eine Ausgestaltung des oder der Informationsbereiche nicht unmittelbar mit dem Grundmodul verbunden ist.

Vorzugsweise sind auch das Grundmodul und/oder das Lichtleitmodul oder alternativ das Grundmodul und die Blendeneinheit mit Kupplungsmitteln ausgebildet, sodass das Grundmodul an einem Lichtleitmodul oder alternativ das Grundmodul an der Blendeneinheit mittels einer Rastverbindung anordenbar ist. Das Grundmodul kann auch sowohl an der Blendeneinheit als auch an dem Lichtleitmodul befestigt sein.

Eine kompakte Bauweise des Grundmoduls wird dadurch ermöglicht, dass bei einer bevorzugten Ausführungsform das Grundmodul mindestens einen Lichtaustrittsbereich aufweist, aus dem das Licht des mindestens einen Leuchtmittels aus dem Grundmodul austritt und das Grundmodul so an dem Lichtleitmodul angeordnet ist, dass sich der mindestens eine Lichtaustrittsbereich nicht mit der mindestens einen Aussparung überlappt, die den mindestens einen Informationsbereich für eine Hinterleuchtung durch dieses Leuchtmittel ausbildet, und in dem Lichtleitmodul mindestens ein Lichtleitelement ausgebildet ist, welche das aus dem mindestens einen Lichtaustrittsbereich des Grundmoduls austretende Licht zu dem hinterleuchtbaren Informationsbereich der mindestens einen Aussparung leitet. Eine für die Anzeige zur Verfügung stehende und genutzte Fläche an der Fahrzeugverkleidung kann somit sehr viel größer als eine Fläche des Grundmoduls ausgeführt sein, die der Betrachtungsseite der Fahrzeugverkleidung zugewandt ist. Hierdurch wird insbesondere die Möglichkeit geschaffen, das Grundmodul so kompakt auszugestalten, dass dieses keine Luftaustauscheinheit benötigt.

Bei einer bevorzugten Ausführungsform ist eine der Blendeneinheit zugewandte Vorderseite des Grundmoduls in der Fläche kleiner als die Fläche des Bereichs der Blendeneinheit, der die hinterleuchtbaren Informationsbereiche überdeckt, wobei mindestens ein Lichtleitelement aus dem Grundmodul an einem Lichtaustrittsbereich austretendes Licht zu einem der hinterleuchtbaren Informationsbereiche leitet.

Vorzugsweise ist die Fahrzeugverkleidung so ausgebildet, dass das Lichtleitmodul zusätzlich zu der den mindestens einen Informationsbereich ausbildenden mindestens einen Aussparung weitere Aussparungen aufweist, die weitere Informationsbereiche für eine Hinterleuchtung ausbilden, das Grundmodul weitere Lichtaustrittsbereiche aufweist, denen jeweils ein individuell ansteuerbares Leuchtmittel zugeordnet ist, und in dem Lichtleitmodul weitere voneinander und dem mindestens einen Lichtleitelement optisch isolierte Lichtleitelemente ausgebildet sind, um jeweils das aus einem der weiteren Lichtaustrittsbereiche austretende Licht zu einem der weiteren Informationsbereiche zu leiten. Bei einer solchen Ausführungsform können eine Vielzahl von Informationen beispielsweise in Form von Symbolen jeweils gezielt hinterleuchtet werden und so eine Information an einen Nutzer vermitteln. Eine Größe des Grundmoduls muss hierbei nicht oder nur unwesentlich verändert werden, um eine ausreichende Anzahl von Leuchtmitteln aufnehmen zu können und den Leuchtmitteln zugeordnete individuelle Lichtaustrittsbereiche bereitzustellen.

Bei einigen Ausführungsformen der Fahrzeugverkleidung ist vorgesehen, dass das Grundmodul mindestens ein zusätzliches individuell ansteuerbares Leuchtmittel umfasst, dessen Licht aus einem zusätzlichen Lichtaustrittsbereich bei einer Ansteuerung austritt und das Lichtleitmodul mindestens eine zusätzliche Aussparung zum Ausbilden mindestens eines zusätzlichen Informationsbereichs aufweist, wobei sich die mindestens eine zusätzliche Aussparung und der mindestens eine zusätzliche Lichtaustrittsbereich bei einer Anordnung des Grundmoduls an dem Lichtleitmodul überlappen, sodass aus dem mindestens einen zusätzlichen Lichtaustrittsbereich austretendes Licht den mindestens einen zusätzlichen Informationsbereich unmittelbar hinterleuchtet. Hierdurch wird die Möglichkeit geschaffen, mindestens ein Lichtleitelement einzusparen und eine direkte Hinterleuchtung von einem Informationsbereich zu nutzen.

Es können jedoch auch alle Informationsbereiche über ein Lichtleitelement hinterleuchtet sein.

Ein Informations- oder Symbolelement kann beispielsweise als opake Schicht mit einem oder mehreren transparenten Bereichen ausgebildet sein. Hierbei legt die Form des einen transparenten Bereichs oder legen die Formen der mehreren transparenten Bereiche die Information fest, welche bei einer Hinterleuchtung wahrnehmbar ist.

Die mindestens eine opake Schicht kann ein Bestandteil eines Grundkörpers des Lichtleitmoduls sein, welcher vorzugsweise aus einem opaken Kunststoffmaterial, vorzugsweise aus einem opaken thermoplastischen Kunststoffmaterial, gebildet ist. Die opake Schicht kann somit eine die Aussparung eines Informationsbereichs überspannende Materialschicht sein, in welcher der eine oder die mehreren transparenten Bereiche beispielsweise als Durchbrechung oder Durchbrechungen ausgebildet sind. Alternativ kann das Informationselement oder Symbolelement mittels einer einen Informationsbereich der Aussparung überdeckenden Folie gebildet sein, welche opake und transparente Bereiche umfasst, wobei die transparenten Bereiche erneut die bei der Hinterleuchtung wahrnehmbare Information, beispielsweise ein oder mehrere Symbole, darstellen.

Bei einer Ausführungsform ist das Lichtleitmodul so ausgebildet, dass es eine Aufnahme für eine Folie aufweist, die mehrere oder alle der einen Informationsbereich ausbildenden Aussparungen überdeckt. Hierdurch wird es möglich, die Lichtleitmodule in großer Stückzahl herzustellen und die in den einzelnen Informationsbereichen zur Anzeige gebrachten Symbole bzw. Informationen individuell über ein Einbringen einer oder mehrerer Folien auf einfache Weise zu individualisieren.

Eine weitere Möglichkeit, die Information bzw. das Symbol, welches in einem Informationsbereich wahrnehmbar ist, festzulegen, besteht darin, den Lichtleiter im Bereich des Informationsbereichs so zu strukturieren, dass Lichtaustrittsbereiche des Lichtleitelements die bei einer Lichtleitung durch das Lichtleitelement wahrnehmbare Information festlegen.

Eine besonders bevorzugte Ausführungsform sieht vor, dass die Informationselemente oder Symbolelemente mittels einer opaken Beschichtung auf einer Rückseite, d.h. der von der Betrachtungsseite abgewandten Seite der Blendeneinheit, ausgebildet sind. Die opake Beschichtung weist transparente oder transluzente Bereiche zur Ausbildung der Information oder Informationen auf. An diesen transluzenten oder transparenten Stellen kann Licht beim Durchleuchten durch die Blendeneinheit hindurchtreten. Bis auf die Beschichtung ist die Blendeneinheit im jenem Bereich, in dem Informationen über transparente und Transluzente Ausnehmungen in der opaken Beschichtung gebildet sind, für eine Durchleuchtung in dem mindestens einen sichtbaren Wellenlänge transparent. Dieser Bereich wird daher immer noch als Fensterbereich bezeichnet, auch wenn Teilbereiche der Blendeneinheit aufgrund der Beschichtung, wo diese keine transparenten oder transluzenten Ausnehmungen oder Aussparungen aufweist, intransparent ist. Der Fensterbereich der Blendeneinheit muss somit zumindest abschnittsweise oder bereichsweise für mindestens einen sichtbaren Wellenlängenbereich für die Durchleuchtung transparent sein. Im Fensterbereich ist somit in der Regel das Blendenmaterial bis auf eine eventuell auf der von der Betrachtungsseite abgewandten Seite ausgebildete opake Beschichtung für mindestens einen sichtbaren Wellenlängenbereich für die Durchleuchtung transparent.

Die opake Beschichtung kann beispielsweise aufgedruckt, aufgesprüht oder auf andere Weise ausgebildet sein.

Die Blendeneinheit kann somit im Fensterbereich bei einigen Ausführungsformen zumindest bereichsweise transparent, bei anderen sogar vollflächig transparent für das Durchleuchten in mindestens einem sichtbaren Wellenlängenbereich des Lichts sein.

Eine weitere wesentliche Verbesserung gegenüber dem Stand der Technik, insbesondere um eine interaktive Verwendung der Anzeigefunktionalität zu erreichen, wird dadurch geschaffen, dass das Grundmodul als Eingabeeinheit einen berührungslos arbeitenden Gestenerkennungsensor umfasst.

Ein Vorteil eines berührungslos arbeitenden Gestenerkennungssensors besteht darin, dass eine mechanische und auch chemische Beeinträchtigung der Fahrzeugverkleidung bei einer Nutzerinteraktion deutlich reduziert ist bzw. gänzlich ausgeschlossen ist. Um eine solche berührungslose Gestenerkennung auszuführen, ist bei einer Ausführungsform vorgesehen, dass das Grundmodul als Sensorelemente einen Infrarotsender und einen Infrarotempfangssensor umfasst, um hiermit Abstandsmessungen in einem Detektionsbereich vor der Blendeneinheit auszuführen.

Vorzugsweise ist die Blendeneinheit aus einem Material ausgeführt, welches transparent für die Infrarotstrahlung des Infrarotsenders und den spektralen Erfassungsbereich des Infrarotempfangssensors ist. Ist auf der Rückseite, d.h. auf der von der Betrachtung abgewandten Seite, der Blendeneinheit eine opake Beschichtung vorzugsweise zum Ausbilden von Informationselementen ausgebildet, so weist die Beschichtung zumindest im Bereich der Sensorelemente, d.h. dort, wo die Blendeneinheit die Sensorelemente überdeckt, oder in einem etwas größeren Bereich hierum eine Aussparung oder Aussparungen bzw. eine Ausnehmung oder Ausnehmungen auf, so dass die Blendeneinheit in diesem Bereich für die Strahlung, die die Sensorelemente aussenden oder empfangen, transparent ist, so dass ein geringe Abschwächung und/oder Streuung dieser Strahlung in der Blendeneinheit auftritt.

Um eine Abschwächung der ausgesandten Infrarotstrahlung als auch der erfassten Infrarotstrahlung zu minimieren, ist bei einer bevorzugten Ausführungsform vorgesehen, dass das zwischen der Blendeneinheit und dem Grundmodul angeordnete Lichtleitmodul Aussparungen für die entsprechenden Sensorelemente aufweist.

Besonders bevorzugt sind die Sensorelemente in dem Grundmodul so angeordnet und in dieses integriert, dass diese aus einer Grundmodulseitenfläche, insbesondere der Vorderseite, vorspringen und in die Aussparungen des Lichtleitmoduls, welche für die Sensorelemente gebildet sind, eingreifen.

Die Oberflächen der Sensorelemente, die der Blendeneinheit zugewandt sind, sind vorzugsweise dunkel, insbesondere schwarz, oder in derselben Farbe ausgeführt wie das Lichtleitmodul. Hierdurch kann erreicht werden, dass die Sensorelemente einen optischen Eindruck der Fahrzeugverkleidung nicht nachteilig beeinflussen und von einer Betrachtungsseite der Blendeneinheit nicht oder kaum wahrnehmbar sind.

Um dennoch für den Nutzer eine Lokalisierungsmöglichkeit des Gestenerkennungssensors zu ermöglichen, sind die Sensorelemente bei einer Ausführungsform zwischen Aussparungen angeordnet, welche hinterleuchtbare Informationsbereiche sind.

Bei einer besonders bevorzugten Ausführungsform ist der Infrarotempfangssensor ausgebildet, reflektierte Infrarotstrahlung richtungs- und/oder ortsaufgelöst zu erfassen. Besonders bevorzugt werden Ausführungsformen, bei denen die aus unterschiedlichen Richtungen auf den Infrarotempfangssensor reflektierte Infrarotstrahlung mittels einer Optik auf unterschiedliche Erfassungselemente abgebildet wird. Hierdurch können iterativ zeitgleich oder zeitversetzt eine Vielzahl von Lichtintensitäts- und/oder Lichtlaufzeitmessungen mittels einer gepulsten Infrarotlichtquelle als Infrarotsender ausgeführt werden und so ein großer Raumbereich vor der Blendeneinheit auf ein Vorhandensein und/oder eine Bewegung von einem Betätigungselement, beispielsweise einem Körperteil eines Nutzers, untersucht werden. Positionsänderungen können zuverlässig und schnell ebenso wie eine Ausdehnung des Betätigungselement ausgewertet werden. Hierdurch wird es möglich, dass vielfältige Gesten, sowohl statische Gesten, welche beispielsweise mit einer bestimmten Handhaltung oder einer Anwesenheit des Betätigungselements in einem bestimmten Raumbereich assoziiert sind, und/oder dynamische Gesten, welche mit einer Bewegung eines Betätigungselements relativ zu dem Gestensensor verknüpft sind, ausgewertet und genutzt werden.

Um eine Informationsvermittlung in einem Informationsbereich zu steigern, ist es vorzugsweise vorgesehen, dass das zugehörige Leuchtmittel ein Mehrfarbleuchtmittel ist, welches gezielt unterschiedlich farbiges Licht emittieren kann.

Vorzugsweise sind die Leuchtmittel als LEDs ausgebildet. Um eine Mehrfarbigkeit zu erreichen, sind die Leuchtmittel vorzugsweise als RGB-LEDs ausgebildet, welche Licht unterschiedlicher Farbe, beispielsweise rotes, grünes und blaues Licht, erzeugen können. Ebenso ist es möglich, einem Lichtaustrittsbereich des Grundmoduls unterschiedliche individuell ansteuerbare Leuchtmittel zuzuordnen, welche jeweils nur Licht einer bestimmten Farbe oder bestimmter Farben emittieren. Über eine Farbaddition können hierüber ebenfalls unterschiedliche farbige Hinterleuchtungen eines Informationsbereichs erreicht werden, sofern eine Lichtintensität der unterschiedlichen Leuchtmittel individuell steuerbar ist.

Vorzugsweise sind von allen Leuchtmitteln die Lichtintensitäten der Lichtemission individuell und graduell steuerbar.

Die Blendeneinheit ist vorzugsweise mit einer geschlossenen Oberfläche ausgebildet. Besonders bevorzugt ist diese Oberfläche glatt und glänzend ausgebildet.

Besonders bevorzugt weist die Fahrzeugverkleidung, wenn keiner der Informationsbereiche hinterleuchtet ist, eine möglichst einheitliche, vorzugsweise dunkle Farbe auf.

Daher ist bei einer bevorzugten Ausführungsform vorgesehen, dass die Blendeneinheit neben dem Fensterbereich zusätzlich einen opaken Bereich umfasst. Beispielsweise wird die Blendeneinheit in einem Zweikomponenten- oder Mehrschrittspritzguss- oder -spritzprägeverfahren hergestellt.

Ferner kann das Blendenelement aus einem Acrylglas, beispielsweise Polymethylmethacrylat (PMMA) hergestellt sein. Im Stand der Technik sind Ausführungen bekannt, die im Auflicht dunkel oder schwarz aussehen, jedoch im Durchlicht eine ausreichende Transmission für eine Hinterleuchtung aufweisen.

Auch das Lichtleitmodul kann bei einer Ausführungsform als getrenntes Teil in einem mehrschrittigen Spritzguss- oder Spritzprägeverfahren hergestellt werden.

Die Lichtleitelemente weisen bei einer bevorzugten Ausführungsform jeweils einen transparenten oder transluzenten Kern, vorzugsweise aus einem Kunststoffmaterial, auf. Die Lichtleitung kann aufgrund verschiedener physikalischer Effekte erfolgen. Zum einen kann der transparente oder transluzente Kern von einem Material ummantelt sein, welches einen geringeren optischen Brechungsindex als das Kernmaterial aufweist. Hierdurch wird die Möglichkeit geschaffen, das Licht, welches unter einem stumpfen Winkel auf die Grenzfläche zwischen dem Kernmaterial und dem ummantelnden Material auftrifft, über Totalreflektion an den Grenzflächen innerhalb des Kernmaterials geleitet wird.

Eine Lichtleitung in dem transparenten oder transluzenten Kernmaterial ist ebenfalls möglich, wenn dieses von einer spiegelnden Ummantelung umgeben ist und die Lichtleitung durch spiegelnde Reflexion an der Ummantelung stattfindet. Alternativ oder zusätzlich zu der Lichtleitung durch Totalreflexion oder spiegelnde Reflexion an der Ummantelung bzw. der Grenzfläche zur Ummantelung kann das Kernmaterial Streuzentren aufweisen und die Lichtleitung über diffuse Streuung in dem Lichtleiter erfolgen. Die Lichtleitung kann in einem Lichtleiter auch abschnittsweise nach unterschiedlichen physikalischen Wirkweisen erfolgen. Zusätzlich zu den Aussparungen, die Informationsbereiche definieren und ein Symbolelement oder ein Informationselement aufweisen, können in dem Lichtleitmodul noch weitere Aussparungen ausgebildet sein, die direkt oder über noch weitere Lichtleitelemente mit noch weiteren Lichtaustrittsbereichen des Grundmoduls verbunden sind, wobei die noch weiteren Aussparungen keine Informationselement oder Symbolelemente aufweisen.
Eine Hinterleuchtung dient in erster Line dazu, die Aufmerksamkeit, d.h. eine Blickrichtung eines Nutzers zu lenken. Sind die Informationselemente in einer opaken Beschichtung einer ansonsten in dem Fensterbereich für die Durchleuchtung mit sichtbarem Licht transparenten Blendeneinheit ausgebildet, so gibt es in der opaken Beschichtung eine Ausnehmung oder mehrere Ausnehmungen oder Aussparungen, die die noch weiteren Aussparungen des Lichtleitmoduls überdecken und einen oder mehrere transparente Bereiche in der opaken Beschichtung ausbilden.

Nachfolgend wird die Erfindung anhand bevorzugter Ausführungsbeispiele unter Bezugnahme auf die Figuren näher erläutert. Hierbei zeigen:
- Fig. 1: eine schematische Darstellung eines Kraftfahrzeug;
- Fig. 2: eine schematische Ansicht einer Fahrzeugverkleidung;
- Fig. 3: eine schematische Explosionszeichnung einer Fahrzeugverkleidung, bestehend aus einer Blendeneinheit, einem Lichtleitmodul und einem als Grundmodul ausgebildeten Funktionsmodul;
- Fig. 4: eine schematische Ansicht eines Grundmoduls;
- Fig. 5: eine schematische Rückansicht eines Lichtleitmoduls;
- Fig. 6: eine schematische Vorderansicht eines Lichtleitmoduls;
- Fig. 7: eine schematische Draufsicht auf eine Fahrzeugverkleidung mit einer Darstellung von in verschiedenen Informationsbereichen hinterleuchtbaren Symbolen; eine
- Fig. 8: schematische Schnittansicht durch eine Fahrzeugverkleidung;
- Fig. 9: eine schematische Schnittansicht, bei der ein Teil der Informationsbereiche durch ein Display hinterleuchtet wird;
- Fig. 10: eine schematische perspektivische Ansicht einer Betrachtungsseite einer Blendeneinheit mit einer opaken Beschichtung auf der von der Betrachtungsseite abgewandten Rückseite;
- Fig. 11: eine schematische perspektivische Ansicht einer von der Betrachtungsseite abgewandten Rückseite der Blendeneinheit nach Fig. 10 und;
- Fig. 12: eine schematische Darstellung der Funktionseinheiten.

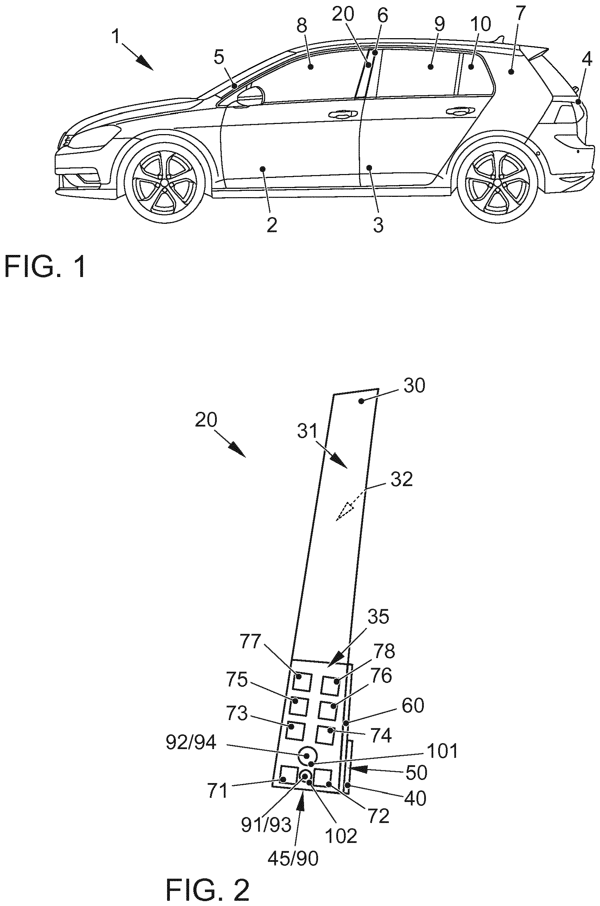

In Fig. 1 ist schematisch eine Seitenansicht eines Kraftfahrzeugs 1 dargestellt. Zu erkennen ist eine linke Fahrzeugseite mit einer vorderen Fahrzeugtür 2 und einer hinteren Fahrzeugtür 3. Ferner weist das Fahrzeug eine Heckklappe 4 auf. Eine vordere und hintere Fahrzeugtür auf der gegenüberliegenden Fahrzeugseite sind nicht dargestellt. Das Fahrzeug weist eine sogenannte A-Säule 5, eine B-Säule 6 und eine C-Säule 7 auf. Insbesondere an diesen verschiedenen Fahrzeugsäulen, aber auch an anderen Stellen, werden Fahrzeugverkleidungen, beispielsweise zum Erzeugen einer ästhetischen Außenansicht und/oder zum Verdecken von darunter befindlichen technischen Einrichtungen verwendet. Insbesondere angrenzend an Seitenfenster 8, 9, 10 können Fahrzeugverkleidungen am Rand zur Abdeckung eines Rahmens verwendet werden. Im dargestellten Ausführungsbeispiel ist eine Fahrzeugverkleidung 20 mit Anzeigefunktionalität als Bestandteil der B-Säulenverkleidung an der vorderen linken Fahrzeugtür 2 ausgebildet. Alternativ oder zusätzlich könnte eine Fahrzeugverkleidung mit Anzeigefunktionalität auch als Bestandteil der B-Säulenverkleidung beispielsweise in der hinteren Fahrzeugtür 3 ausgebildet sein. Andere Ausführungsformen sehen vor, dass die Fahrzeugverkleidung nicht Bestandteil einer der Fahrzeugtüren ist, sondern in einem unbeweglichen Karosserieteil als Verkleidung eingesetzt wird.

In Fig. 2 ist eine schematische Ansicht einer Fahrzeugverkleidung 20 mit Anzeigefunktionalität dargestellt. Gleiche technische Merkmale sind in allen Figuren mit denselben Bezugszeichen gekennzeichnet. Die Fahrzeugverkleidung 20 umfasst eine Blendeneinheit 30, welche eine Betrachtungsseite 31, welche einem Nutzer zugewandt ist, aufweist. Gegenüberliegend zu der Betrachtungsseite 31 liegt eine Rückseite 32, welche der Fahrzeugkomponente zugewandt ist, an der die Fahrzeugverkleidung 20 angeordnet ist.

Zwischen einer Funktionseinheit 40, die als Grundmodul 50 ausgebildet ist, ist ein Lichtleitmodul 60 an der Rückseite 32 der Blendeneinheit 30 angeordnet. Das Lichtleitmodul 60 umfasst in der dargestellten Ausführungsform Informationsbereiche 71-78. Vorzugsweise weist jeder Informationsbereich ein Informations- oder Symbolelement 81-88 auf. Das Informations- oder Symbolelement 81-88 legt für den entsprechenden Informationsbereich 71-78 jene Information, beispielsweise in Form eines Symbols, fest, die bei einer Be- bzw. Hinterleuchtung von einem Betrachter wahrnehmbar ist.
Die Symbole sind hier exemplarisch schematisch als römische Zahlen I bis VIII dargestellt. Vorzugsweise wird ein solches Informationselement, auch Symbolelement 81-88 genannt, über Bereiche unterschiedlicher Transmission ausgebildet. Vorzugsweise existieren opake nicht transparente und transparente oder transluzente Bereiche. Eine Form der transparenten und transluzenten Bereiche legt dann die Information, beispielsweise ein Symbol oder Symbole, fest, die bei einer Be- oder Hinterleuchtung in dem Informationsbereich 71-78 entsprechend erfassbar sind.

Um die entsprechende Information eines der Informationsbereiche 71-78 wahrnehmen zu können, weist die Blendeneinheit 30 zumindest in jenem Bereich, in dem die Informationsbereiche 71-78 des Lichtleitmoduls angeordnet sind, einen Fensterbereich 35 auf, in dem die Blendeneinheit 30 für ein Durchstrahlen mit Licht zumindest bereichsweise transparent ist.

Informationselemente oder Symbolelemente können in dem Lichtleitmodul 60 oder an der Rückseite 32 der Blendeneinheit 30 Informationen ausgebildet sein. Sind die Informationselemente oder Symbolelemente in dem Lichtleitmodul 60 ausgebildet ist der Fensterbereich 35 vorzugsweise vollflächig für eine Hinterleuchtung mit sichtbarem Licht transparent. Sind die Symbolelemente oder Informationselement 81-88 über transparent oder transluzente Bereiche in einer opaken Beschichtung der Rückseite 32 der Blendeneinheit 30 ausgebildet, so ist der Fensterbereich 35 abschnitts- oder bereichsweise für die Hinterleuchtung mit sichtbarem Licht transparent.

Auf einer von der Betrachtungsseite 31 der Blendeneinheit 30 abgewandten Seite 32 ist die Funktionseinheit 40 angeordnet, welche ein oder mehrere Leuchtmittel (nicht dargestellt) umfasst, welche über eine Hinterleuchtung an der Betrachtungsseite 31 der Blendeneinheit eine wahrnehmbare Information erzeugen können. Vorzugsweise erfolgt dies, indem die Symbol- oder Informationselemente 81-88 be- oder hinterleuchtet werden. Diese sind in der dargestellten Ausführungsform in einem zwischen der Funktionseinheit 40 und der Blendeneinheit 30 angeordneten Lichtleitmodul 60 ausgebildet.

Da eine Fahrzeugverkleidung 20 mit Anzeigefunktionalität insbesondere außen an einer Fahrzeugkarosserie angeordnet wird, ist die Fahrzeugverkleidung Umwelteinflüssen, insbesondere Nässe und Feuchtigkeit, ausgesetzt. Funktionselemente, die zur Funktionseinheit 40 gehören, wie beispielsweise Leuchtmittel und/oder eine Erfassungssensorik einer Eingabeeinheit, welche empfindliche, zumeist elektronische Bauteile umfassen, müssen gegen Feuchtigkeit geschützt werden. Bei der hier vorgeschlagenen Lösung sind die Funktionselemente wie Leuchtmittel und Sensoren in dem Grundmodul 50 angeordnet, welches ein wasserdichtes vollständig umschlossenes Gehäuse 59 aufweist. Dieses Grundmodul 50 ist hinter der Blendeneinheit 30 angeordnet und unmittelbar an der Blendeneinheit 30 oder an der zwischen der Blendeneinheit 30 und dem Grundmodul 50 angeordneten Lichtleitmodul 60 befestigt. Vorzugsweise erfolgt eine Befestigung an der Blendeneinheit 30 und/oder an dem Lichtleitmodul 60 über eine Rast- oder Schnappverbindung. Vorteil ist ein einfacher Zusammenbau und eine Möglichkeit, die einzelnen Bestandteile bei einer Wartung zerstörungsfrei voneinander trennen zu können.

Zusätzlich zu Leuchtmitteln umfasst die Funktionseinheit 40 vorzugsweise eine Eingabeeinheit 45, welche berührungslos Nutzereingaben erfassen kann. Bei dem in Fig. 2 dargestellten Ausführungsbeispiel umfasst die Funktionseinheit 40 bzw. das Grundmodul 50 als Eingabeeinheit 45 einen Gestenerkennungssensor 90, der als Sensorelemente 91, 92 einen Infrarotsender 93 und einen Infrarotempfangssensor 94 aufweist. Diese sind beide ebenfalls hinter der Blendeneinheit 30 und in dem Grundmodul 40 ausgebildet und von dessen Gehäuse umschlossen und integriert. Um die Funktionsweise des Gestenerkennungssensors 90 nicht zu beeinträchtigen, sind in dem Lichtleitmodul 60 Funktionsaussparungen 101, 102 ausgebildet. Vorzugsweise sind die Sensorelemente 91, 92, d.h. der Infrarotsender 93 und der Infrarotempfangssensor, in Vorsprüngen des Grundmoduls angeordnet, sodass diese in und durch die Funktionsaussparungen 101 und 102 des Lichtleitmoduls 60 greifen. Die Blendeneinheit 30 ist zumindest im Bereich der Funktionsaussparung 101, 102, vorzugsweise im gesamten Fensterbereich 35, für Infrarotstrahlung, die der Gestenerkennungssensor 90 nutzt, transparent. Die Blendeneinheit 30 überdeckt die Funktionsaussparungen 101, 102.

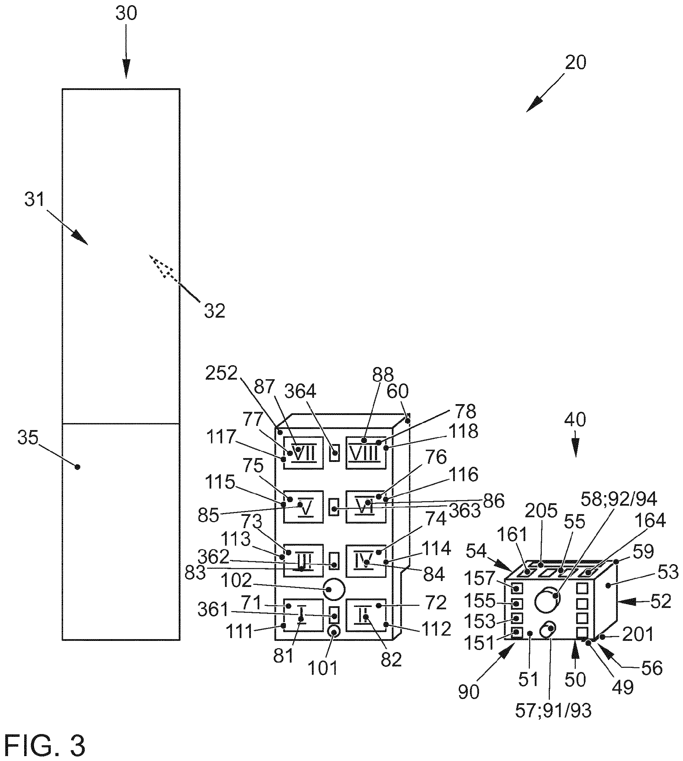

In Fig. 3 ist schematisch eine Explosionsansicht einer Fahrzeugverkleidung 30 mit Anzeigefunktionalität und Nutzereingabeerfassungsfunktionalität dargestellt. Es sind auch Ausführungsformen denkbar, bei denen die Eingabefunktionalität nicht ausgebildet ist. In Fig. 3 ist gut zu erkennen, dass die Fahrzeugverkleidung 20 drei funktionelle Komponenten, die Blendeneinheit 30, das Lichtleitmodul 60 und die als Grundmodul 50 ausgebildete Funktionseinheit 40 umfasst.

Die Blendeneinheit 30 ist vorzugsweise aus einem Kunststoffmaterial, bevorzugt einem thermoplastischen Kunststoff, insbesondere aus Polymethylmethacrylat (PMMA), welches auch als Acrylglas bezeichnet wird, gefertigt, welches beispielsweise unter den Handelsnamen Plexiglas, Acrylite, Lucite oder Perspex gehandelt wird.
Je nach Ausgestaltung kann dieses im sichtbaren Wellenlängenbereich vollständig transparent und klar oder transparent und eingefärbt sein. Ebenso ist es möglich, PMMA opak auszubilden.

Besondere Ausgestaltungen von Acrylglas weisen eine dunkle, nahezu schwarze Anmutung im Auflicht auf, besitzen jedoch für eine Durchleuchtung eine nennenswerte Transmission, sodass durch eine solche Ausführungsform des Acrylglases eine Darstellung von hinterleuchteten Symbolen und Informationen möglich ist.

Die Blendeneinheit 30 weist zumindest einen Fensterbereich 35 auf, der im sichtbaren Wellenlängenbereich für eine Durchleuchtung eine ausreichende Transmission aufweist. In diesem Fensterbereich 35 ist die Blendeneinheit 30 auf für infrarote Strahlung, die von dem Gestenerkennungssensor 90 verwendet wird, in beiden Transmissionsrichtungen durchlässig.

Die Betrachtungsseite 31 ist vorzugsweise mit einer glatten oder bevorzugt glänzend ausgebildeten Oberfläche versehen. Andere Ausführungsformen können auch eine matte Oberfläche insbesondere in Bereichen aufweisen, die nicht zum Fensterbereich 35 gehören.

Das Grundmodul 50 weist eine Vorderseite 51 auf, welche einer Rückseite 32 der Blendeneinheit 30 im zusammengefügten Zustand zugewandt ist. Bei der dargestellten Ausführungsform weist das Grundmodul 50 an der Vorderseite 51 Lichtaustrittsbereiche 151-158 auf, die in ihrer Anzahl vorzugsweise mit einer Anzahl von Informationsbereichen 71-78 des Lichtleitmoduls 60 korrespondieren. Im Innern des Grundmoduls 50 ist jedem der Lichtaustrittsbereiche 151-158 jeweils mindestens ein Leuchtmittel (nicht dargestellt) zugeordnet. Diese Leuchtmittel können individuell von einer in dem Grundmodul 50 enthaltenen Steuerelektronik angesteuert werden und verursachen jeweils einen Lichtaustritt aus dem entsprechenden zugeordneten Lichtaustrittsbereich 151-158. Die Leuchtmittel sind im Innern des Grundmoduls 50 so angeordnet, dass ein Leuchtmittel nur Licht durch den entsprechenden zugeordneten Lichtaustrittsbereich 151-158 des Grundmoduls 50 emittiert. Dies bedeutet, dass die den verschiedenen Lichtaustrittsbereichen 151-158 zugeordneten verschiedenen Leuchtmittel im Innern des Grundmoduls gegeneinander optisch isoliert sind.

An der Vorderseite 51 des Grundmoduls 50 sind darüber hinaus die Sensorelemente 91, 92, welche entsprechend den Infrarotsender 93 und den Infrarotempfangssensor 94 enthalten, zu erkennen. Die Sensorelemente 91, 92 sind in zylindrisch geformte Vorsprünge eingehaust, die Bestandteil des Gehäuses 59 des Grundmoduls 50 sind.
In dem kleinen zylindrischen Vorsprung 57 ist der Infrarotsender 93 und in dem großen zylindrischen Vorsprung 58 der Infrarotempfangssensor 94 angeordnet. Das Grundmodul 50 weist bei der dargestellten Ausführungsform zusätzlich an einer Oberseite 55 weitere Lichtaustrittsbereiche 161-164 auf.

Auch die Seitenwand 53 oder die gegenüberliegende Seitenwand 54 des Gehäuses 59 des Grundmoduls 50 können weitere Lichtaustrittsbereiche aufweisen. Ebenso können an einer Unterseite 56 weitere Lichtaustrittsbereiche vorgesehen sein.

Alternativ oder zusätzlich zu den weiteren Lichtaustrittsbereichen 161-164 an der Oberseite 55, an einer der Seitenwände 53, 54 oder an der Unterseite 56 des Gehäuses 59 des Grundmoduls können Steckkontakte 205 für ein Funktionsmodul, beispielsweise eine frei programmierbare Anzeige, wie beispielsweise ein hinterleuchtetes LCD-Display oder OLED-Display oder Ähnliches, angeordnet sein. Ferner weist das Grundmodul 50 beispielsweise an der Unterseite 56 Anschlusskontakte 47 auf, über die das Grundmodul 50 sowohl mit anderen Fahrzeugkomponenten informationstechnisch verbunden werden kann als auch mit elektrischer Energie versorgt wird. Alternativ oder zusätzlich kann eine optische Schnittstelle für eine optische Informationsverbindung vorgesehen sein. Die Anschlusskontakte für eine informationstechnische Verbindung zu anderen Fahrzeugkomponenten und die Energieversorgung können getrennt ausgebildet werden und auch an der Rückseite oder einer anderen Wand des Gehäuses ausgebildet sein. Eine Anordnung an unterschiedlichen Wänden des Gehäuses ist möglich.

Das Lichtleitmodul 60 weist neben den Funktionsaussparungen 101 und 102 zum Aufnehmen des kleinen zylindrischen Vorsprungs 57 und des großen zylindrischen Vorsprungs 58 die Informationsbereiche 71-78 auf, die über Aussparungen 111-118 ausgebildet sind. Die Aussparungen 111- 118 sind so ausgebildet, dass in eine der Aussparungen 111-118 eingestrahltes Licht nicht in einer der anderen Aussparungen 111-118 strahlt. Die Aussparungen sind optisch gegeneinander isoliert. Beispielsweis ist das Material in dem die Aussparungen ausgebildet sind opak.

Bei der dargestellten Ausführungsform ist das Grundmodul 50 so kompakt ausgeführt, dass eine Vorderseite 51 des Grundmoduls wesentlich kleiner als jener Bereich ist, über den sich die durch die Aussparung 111-118 definierten Informationsbereiche 71-78 erstrecken.

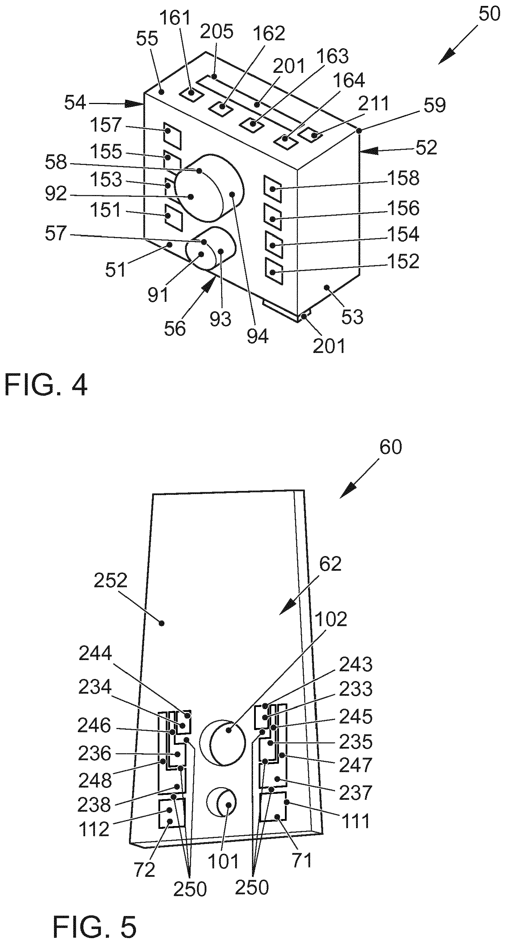

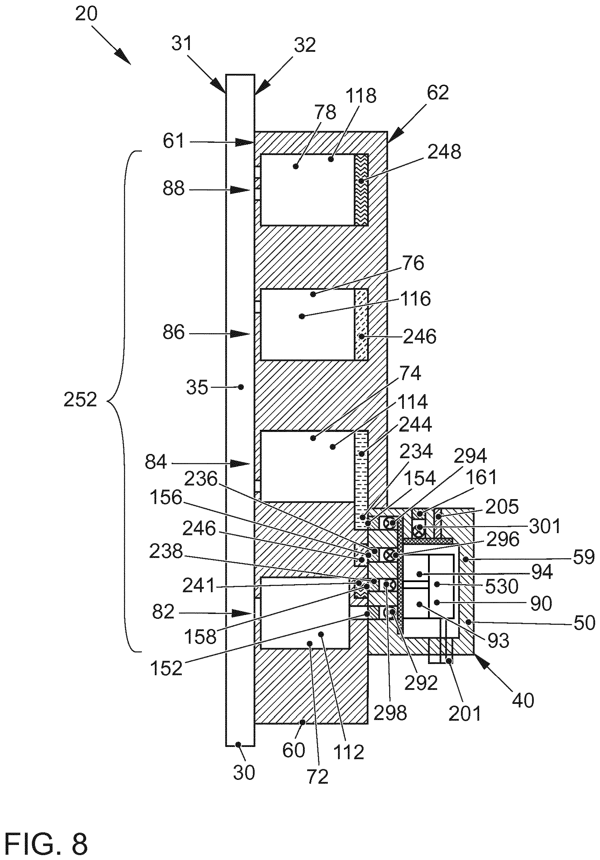

Bei der dargestellten Ausführungsform können lediglich die Informationsbereiche 71, 72 unmittelbar durch aus den Lichtaustrittsbereichen 151, 152 austretendes Licht entsprechend hinterleuchtet werden. Das aus den anderen Lichtaustrittsbereichen 153-158 austretende Licht wird zu den zugeordneten Informationsbereichen 73-78 über in dem Lichtleitmodul 60 ausgebildete Lichtleiterelemente zu den entsprechenden Informationsbereichen 73-78 geleitet. Die einzelnen Lichtleiterelemente, die in den Fig. 5 und 8 abschnittsweise dargestellt und mit den Bezugszeichen 243-248 gekennzeichnet sind, sind hierbei optisch gegeneinander isoliert, sodass das aus einem der Lichtaustrittsbereiche 153-158 austretende Licht jeweils über das zugeordnete Lichtleiterelement nur zu dem entsprechend zugeordneten Informationsbereich 73-78, d.h. in die entsprechende Aussparung 113-118, geleitet wird.

Die Entkopplung der Lichtaustrittsbereiche 151-158 des Grundmoduls von den eigentlichen hinterleuchteten Informationsbereichen 71-78 schafft eine große Flexibilität. Identische Grundmodule können so mit unterschiedlichen Lichtleitmodulen und Blendeneinheiten kombiniert werden, die entsprechend an unterschiedliche Karosserieformen individuell angepasst sein können. Ebenfalls kann eine Anzahl der in dem Lichtleitmodul ausgebildeten Informationsbereiche variieren. Es sind Ausführungsformen möglich, bei denen keiner der Informationsbereiche unmittelbar ohne Zwischenschaltung eines Lichtleitelements hinterleuchtet wird.

Dieses erleichtert einen Einbau in einem Fahrzeug, da eine zur Verfügung stehende benötigte Bauraumtiefe zur Aufnahme der Fahrzeugverkleidung über eine große Fläche der Fahrzeugverkleidung gering sein kann und nur im Bereich, in dem das Grundmodul angeordnet ist, etwas größer sein muss. Beispielsweise kann das Grundmodul in einer Fahrzeugtür in einem Bereich eingebaut werden, in die diese Bauartbedingt eine große Tiefe aufgrund der Aufnahmemöglichkeit von Türschloss und Fensterescheibe aufweist, während sich diese zu einer oberen Kante hinsichtlich der Tiefe deutlich verjüngen kann, Im Extremfall bis auf die Materialstärke der Blendeneinheit der Fahrzeugverkleidung.

Bei einigen Ausführungsformen, insbesondere solchen, die keine Eingabeeinheit für eine Nutzerinteraktion aufweisen, kann das Grundmodul versetzt zu der Außenfläche der Blendeneinheit angeordnet sein.

Die weiteren Lichtaustrittsbereiche 161-164sind vorzugsweise direkt oder über weitere Lichtleitelemente mit weiteren Hinterleuchtungsbereichen gekoppelt.
Diese weisen kein Informationselement oder Symbolelement und vermittelt lediglich über die Hinterleuchtung an sich oder eine Farbe, Intensität, zeitliche Dynamik der Hinterleuchtung (Intensität, Farbwechsel, Dauer der Hinterleuchtung etc.) usw. eine Information an den Nutzer. Die weiteren Hinterleuchtungsbereiche 361-364 können beispielsweise gemeinsam in einer Reihe zwischen den Informationsbereichen 71-78 angeordnet sein und über eine gezielte Ansteuerung eine Aufmerksamkeit des Nutzers optisch lenken. Beispielsweise in dem über selektives An- und Ausschalten ein wandernder Leuchtpunkt erzeugt wird. Weitere Lichtaustrittsbereiche zum Hinterleuchten der weiteren Hinterleuchtungsbereiche können auch an der Vorderseite des Grundmoduls zusätzlich zu den Lichtaustrittsbereichen angeordnet sein, die die Informationsbereiche hinterleuchten.

In jedem Informationsbereich 71-78 ist in der dargestellten Ausführungsform ein Symbolelement 81-88 vorgesehen. Dieses ist vorzugsweise in einer Materialschicht ausgebildet, welche die entsprechende Aussparung 111-118 des entsprechenden Informationsbereichs 71-78 überdeckt und opake und transparente Bereiche aufweist. Die transparenten Bereiche können beispielsweise in Form von Durchbrechungen durch eine ansonsten opak ausgebildete Materialschicht gebildet sein. Eine Form der transparenten Bereiche legt dann die bei der Hinterleuchtung erkennbare Information fest.

Alternativ kann ein Informationselement darüber ausgebildet werden, dass eine transparente Materialschicht quasi mit der inversen Information, beispielsweise in Form einer opaken Farbschicht, bedeckt wird. Diese kann beispielsweise aufgedruckt oder unter Verwendung einer Maske aufgesprüht werden. Wieder alternativ kann eine vollflächig opake Schicht, welches eine durchgefärbte Materialschicht oder eine Farbschicht sein kann, mittels eines Lasers lokal abgetragen oder durchbrochen werden.

Die transpansparente Materialschicht kann auch das Material im Fensterbereich der Blendeneinheit sein, welches an der Rückseite mit einer opaken Beschichtung, in der die Symbolelemente oder Informationselemente ausgebildet sind, versehen ist.

Bei einigen Ausführungsformen kann vorgesehen sein, dass in das Lichtleitmodul eine Folie eingelegt oder eingeschoben wird, in der die einzelnen Informationselemente ausgebildet sind. Hierüber wird eine einfache Individualisierung der Lichtleitmodule einer Serienfertigung möglich, sodass einzelne Ausführungsformen unterschiedliche Informationselemente je nach Ausstattung des Fahrzeugs, für den die Fahrzeugverkleidung bzw. das Lichtleitmodul vorgesehen ist, aufweisen können.
Zusätzlich zu den Informationsbereichen 71-78, die über die Aussparungen 111-118 gebildet sind, kann das Lichtleitmodul weitere hinterleuchtbare Aussparungen 131-134 aufweisen, welche beispielsweise über zweite Lichtleiterelemente, welche erneut gegeneinander optisch isoliert sind, mit den weiteren Lichtaustrittsbereichen 161-164 an der Oberseite 55 des Grundmoduls 50 gekoppelt sind, wenn das Grundmodul 50 mit seiner Vorderseite 51 an der Rückseite 62 des Lichtleitmoduls 60 angeordnet ist.

In Fig. 4 ist eine perspektivische Ansicht eines Grundmoduls schematisch dargestellt. Gleiche technische Merkmale sind in allen Figuren mit denselben Bezugszeichen versehen. Zu erkennen ist bei dieser Ausführungsform ein Steckverbinder 201 für eine informationstechnische Kopplung mit anderen Fahrzeugsystemen sowie für die Energieversorgung der einzelnen Funktionseinheiten, wie Leuchtmittel, Infrarotfassungssensor etc., in dem Grundmodul 50.

Bei einigen Ausführungsformen weist das Grundmodul ein Luftaustauschelement 211 auf, welches beispielsweise eine Membran umfasst, welche zwar einen Gasaustausch ermöglicht, jedoch ein Eindringen von Feuchtigkeit in das Innere des Grundmoduls 50 verhindert. Auch anders ausgebildete Luftaustausch- oder Entlüftungseinheiten können in das Gehäuse 59 des Grundmoduls 50 integriert sein. Bevorzugt werden jedoch Ausführungsformen, bei denen das Gehäuse, welches vorzugsweise aus thermoplastischen Kunststoffen gefertigt ist, vollständig thermisch verschweißt ist. Dieses ist insbesondere dann möglich, wenn die Hohlräume im Inneren klein gestaltet werden können und die in dem Grundmodul enthaltene Elektronik so ausgestaltet wird, dass eine Wärmeabfuhr über die Gehäusewand zuverlässig möglich ist. Bei einzelnen Ausgestaltungen kann für diese Zwecke in die Gehäusewand des Grundmoduls ein wärmeleitendes Element integriert sein.

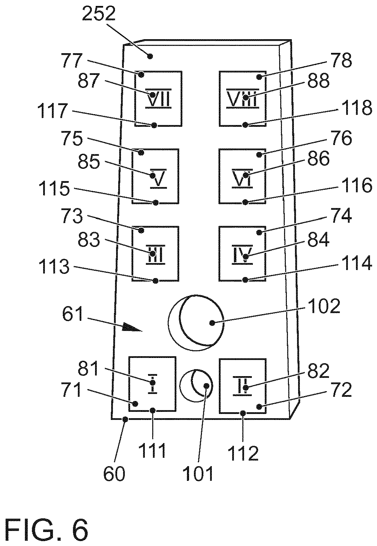

In Fig. 5 und Fig. 6 sind entsprechend eine Ansicht einer Rückseite 62 des Lichtleitmoduls 60 und einer Vorderseite 61 des Lichtleitmoduls 60 schematisch dargestellt. Im unteren Bereich der Rückseite sind die Aussparungen 111, 112 als Informationsbereiche 71, 72 zu erkennen, welche jeweils unmittelbar durch aus einem Lichtaustrittsbereich eines Grundmoduls austretendes Licht hinterleuchtet werden können. Ferner sind Lichteinkoppelbereiche 233-238 der Lichtleiterelemente 243-248 zu erkennen. Diese sind durch opake Stege 250 des Lichtleitmoduls 60 gegeneinander optisch isoliert. Wie aus Fig. 5 zu erkennen ist, sind die Lichtleiter 243-248 zumindest in jenem Bereich 252, in dem in der Vorderseite die Informationsbereiche 73-78 ausgebildet sind, an der Rückseite 62 durch ein opakes Material überdeckt.
In der dargestellten Ausführungsform sind die Lichtleitelemente 243-248 überall dort opak abgedeckt, wo sie nicht von dem Grundmodul 50 überdeckt werden. Hierdurch kann sichergestellt werden, dass die Informations- oder Symbolelemente, die in den Aussparungen 113-118 ausgebildet sind, nicht zu erkennen sind, sofern nicht Licht in das entsprechende Lichtleitelement 243-248 in dessen Einkoppelbereich 133-138 eingekoppelt wird.

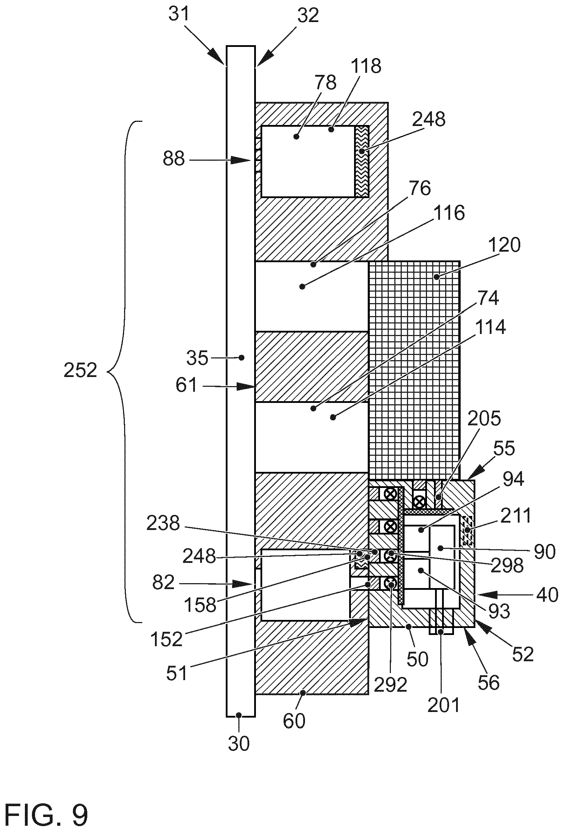

Bei einer anderen Ausführungsform sind zumindest einige Aussparungen, die bei einer Anordnung des Grundmoduls an der Rückseite des Lichtleitmoduls durch dieses nicht überdeckt sind und benachbart zu der Oberseite des Grundmoduls angeordnet sind, weder durch opakes Material verdeckt noch mit einem Lichtleiter ausgestattet, sodass ein auf das Grundmodul aufgestecktes Display die in den entsprechenden Informationsbereichen darzustellende Information erzeugt. Zusätzlich können andere Aussparungen auch bei einer solchen Ausführungsform über ein Lichtleiterelement mit dem Grundmodul gekoppelt sein. Eine solche Ausführungsform ist unten im Zusammenhang mit Fig. 9 erläutert.

In der Vorderansicht des Lichtleitmoduls 60, die in Fig. 6 dargestellt ist, sind die einzelnen Symbolelemente 81-88 der Informationsbereiche 71-78 zu erkennen. Der Begriff Symbolelement und Informationselement werden in dieser Beschreibung synonym verwendet. Die Symbole, die bei einer Hinterleuchtung zu erkennen sind, sind hier beispielsweise aus Gründen der Einfachheit als römische Zahlen "I" bis "VIII" dargestellt. Die Konturen der Buchstaben sind Durchbrechungen des opaken Materials des Lichtleitmoduls 60, welches die Aussparungen 111 bis 118, beispielsweise jeweils an einer Vorderseite, überdeckt.

Wird ein in großer Stückzahl hergestelltes Lichtleitmodul in Fahrzeugen eingesetzt, die nicht alle Symbolelemente oder Informationsbereiche oder Hinterleuchtungsbereiche nutzen, so können einzelne dieser Informationsbereiche (Symbolelemente) beispielsweise mit opakem Material abgeklebt werden.

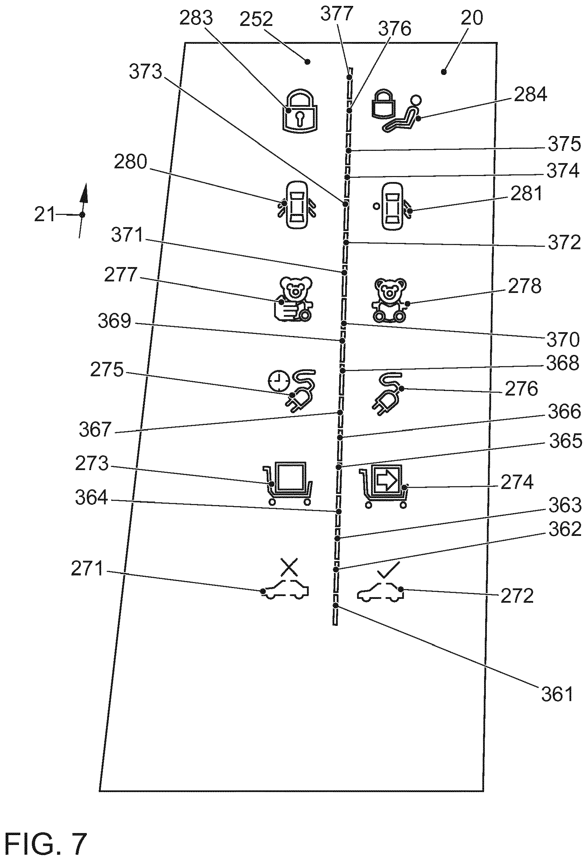

In Fig. 7 ist eine schematische Draufsicht auf eine Fahrzeugverkleidung 20 dargestellt, bei der zur Veranschaulichung alle Informationsbereiche zur Darstellung der verschiedenen Informationselemente hinterleuchtet sind. Die einzelnen Informationsbereiche 271-284 sind paarweise übereinander, d.h. entlang einer Längsrichtung 21 der Fahrzeugverkleidung, angeordnet. Bei dieser Ausführungsform erstreckt sich ein Fensterbereich 35, in dem die Informationsbereiche 271-284 ausgebildet sind, nahezu über die gesamte Längsrichtung 21 der Fahrzeugverkleidung 20. Zwischen den paarweise angeordneten Informationsbereichen 271-284 sind weitere Hinterleuchtungsbereiche 361-377 angeordnet.
Diese können dazu genutzt werden, bei einer Hinterleuchtung eine Aufmerksamkeit eines Nutzers in einen bestimmten Bereich der Blendeneinheit 30 zu führen. Dies kann beispielsweise darüber erfolgen, dass ein sich dynamisch bewegender Lichtpunkt dadurch erzeugt wird, dass die für die Hinterleuchtung verwendeten Leuchtmittel nacheinander sukzessive ein- und ausgeschaltet werden. Die verschieden dargestellten Informationselemente 271-284 sind verschiedenen Fahrzeugfunktionen und Funktionalitäten zugeordnet. Die Informationsbereiche 271, 272 geben an, ob ein Nutzer sein Mobiltelefon mit dem Fahrzeug koppeln kann oder nicht. Die Informationsbereiche 273, 274 geben an, ob in den Kofferraum des Fahrzeugs Ware eingestellt ist oder nicht. Die Informationsbereiche 275, 276 betreffen eine elektrische Aufladung von Energiespeichern des Fahrzeugs und sind mit einer zeitverzögerten oder einer unmittelbar erfolgenden Aufladung verknüpft. Die Informationsbereiche 277, 278 sind mit einer Erfassungsfunktionalität für Objekte verknüpft, die beispielsweise ein RFID-Element umfassen, und zeigen an, ob mit einem RFID-Element versehene Objekte als im Fahrzeug befindlich erfasst oder nicht erfasst sind. Die restlichen vier Informationsbereiche sind mit dem Öffnen von Türen bzw. der Verriegelung des Fahrzeugs verknüpft.

Es versteht sich, dass hier bloß beispielhafte Symbole und beispielhafte Fahrzeugfunktionen für die Informationsbereiche dargestellt sind. Neben Symbolen können auch alphanumerische Informationen angezeigt werden.

Vorzugsweise sind die Leuchtmittel, welche die Informationsbereiche individuell und gezielt hinterleuchten, so ausgebildet, dass diese unterschiedlich farbiges Licht erzeugen können. Jeder Informationsbereich kann somit vorzugsweise beispielsweise gesteuert alternativ rot, grün oder blau hinterleuchtet werden. Über eine grüne Hinterleuchtung kann beispielsweise eine Aktivierung der mit dem entsprechenden Informationselement/Symbolelement verknüpften Funktion angedeutet werden, über eine rote Hinterleuchtung entsprechend eine Deaktivierung. Ein Wechsel zwischen der Aktivierung und Deaktivierung kann beispielsweise über eine blaue Hinterleuchtung angedeutet werden, welche beispielsweise zusätzlich, um den dynamischen Wechselvorgang anzudeuten, blinkend ausgeführt wird. Es versteht sich für den Fachmann, dass auch andersfarbige, insbesondere mischfarbige Hinterleuchtungen, welche durch Farbaddition der Grundfarben Rot, Grün und Blau erzeugbar sind, möglich sind. Ferner kann eine Helligkeit der Hinterleuchtung und auch eine Dynamik im Hinblick auf Helligkeit, Farbe, Ein- und Ausschalten usw. für jedes der Informationselemente frei gestaltet werden, um eine Informationsvermittlung an einen Betrachter zu steuern.

In Fig. 8 ist eine schematische Schnittansicht durch eine Fahrzeugverkleidung 20 mit Anzeigefunktionalität und Nutzerinteraktion dargestellt. Dimensionen der einzelnen Elemente sind nicht realitätsgetreu. Eine Fläche der Vorderseite 51 des Grundmoduls 50 ist jedoch kleiner als ein Bereich 252 über den sich die Informationsbereiche 72-78 erstrecken. Zu erkennen sind die Blendeneinheit 30 sowie das wasserdicht gekapselte Grundmodul 50, welches sämtliche Funktionselemente der Fahrzeugverkleidung 20 umfasst. Dazwischen ist das Lichtleitmodul 60 angeordnet. Gut zu erkennen sind die einzelnen über Aussparungen gebildeten Informationsbereiche 72, 74,76, 78 sowie die entsprechenden Lichtleitelemente 244, 246, 248. Eine Zuordnung der Einkoppelbereiche 234,236, 238 zu den Lichtleitelementen 244,246, 248 in den entsprechenden Aussparungen sind über die Schraffur angedeutet. Die einzelnen Leuchtmittel 292, 294, 296, 298 in dem Grundmodul 50 sind jeweils optisch gegeneinander in dem Grundmodul abgeschirmt und emittieren Licht über den zugeordneten Lichtaustrittsbereich 152, 154, 156, 158. Ebenfalls schematisch zu erkennen sind der Infrarotsender 93 und der Infrarotempfangssensor 94. Dieser ist beispielsweise so ausgebildet, dass er über eine Optik aus verschiedenen Raumrichtungen zu dem Infrarotempfangssensor 94 zurückreflektierte infrarote Strahlung zeitgleich über mehrere Sensoreinheiten erfassen kann. Beispielsweise wird so der Raum vor der Fahrzeugverkleidung in einem 31x31 Bereiche umfassenden Array hinsichtlich des Vorhandenseins von Betätigungselementen untersucht. Für die einzelnen Raumrichtungen wird jeweils ein Abstand eines gegebenenfalls vorhandenen reflektierenden Betätigungselements (Objekts) sowie eine entsprechende Reflexionsintensität ermittelt. Hierfür wird der Infrarotsender 93 vorzugsweise gepulst betrieben. Der Abstand kann unter anderem aus einer Signallaufzeit der Infrarotstrahlung und/oder der Reflexionsintensität ermittelt werden.

Anhand der ermittelten Abstände und/oder Intensitäten für die unterschiedlichen Raumrichtungen vor dem Sensor werden statische und/oder dynamische Gesten ausgewertet und zur Steuerung der Funktionalität verwendet. Eine Steuerung, die die Gesten auswertet und die Leuchtmittel ansteuert sowie Signale an andere Fahrzeugkomponenten erzeugt, kann in dem Grundmodul ausgeführt sein oder in einem Steuergerät umgesetzt sein, welches mit der Fahrzeugverkleidung 20 gekoppelt ist. In dem Grundmodul sind jedoch die elektronischen Ansteuerungen sowohl für die Leuchtmittel 292-298 als auch für den Gestenerkennungssensor 90 vollständig enthalten.

Fig. 9 zeigt eine schematische Schnittansicht ähnlich zu der nach Fig. 8. wie oben bereits erwähnt sind bei dieser Ausführungsform einige Aussparungen 84, 86 direkt von einem Display 120 oder Bildschirm hinterleuchetet, welches wasserdicht ausgeführt ist und auf das Grundmodul 50 aufgesteckt ist.
Die Aussparungen 84, 86 in dem Lichtleitmodul 60 sind somit weder mit einem Lichtleitelement ausgebildet noch von hinten abgedeckt. Somit kann das hinter die Rückseite 62 des Lichtleitmoduls 60 angeordnete Display 120 die Information in den zugeordneten Informationsbereichen 74, 76 anzeigen. Hierdurch wird eine sehr hohe Flexibilität hinsichtlich der anzeigbaren Information erreicht.

Bei der gezeigten Ausführungsform ist ein Informationsbereich 78 nach wie vor über ein Lichtleitelement 248 mit einem Leuchtmittel 298 des Grundmoduls gekoppelt und von diesem hinterleuchtet. Zusätzlich ist der Informationsbereich 72 direkt hinterleuchtet.

Andere Ausführungsformen die direkte Hinterleuchtung und/oder die über ein Lichtleitelement ausgeführte Hinterleuchtung fehlen.

Bei der gezeigten Variante der Fig. 9 ist das Grundmodul identisch zu dem nach Fig. 8 ausgebildet. Es wäre jedoch auch möglich, nicht benötigte Leuchtmittel einzusparen.

Gut zu erkennen sind in Fig. 8 und 9 die Leuchtmittel 292-298 sowie noch ein weiteres Leuchtmittel 301, welche alle vorzugsweise als Mehrfarb-LEDs, beispielsweise RGB-LEDs, ausgebildet sind. Alternativ können jedem Lichtaustrittsbereich 152-158, 161 jeweils mehrere Leuchtmittel, welche beispielsweise unterschiedlich farbiges Licht erzeugen, zugeordnet sein.

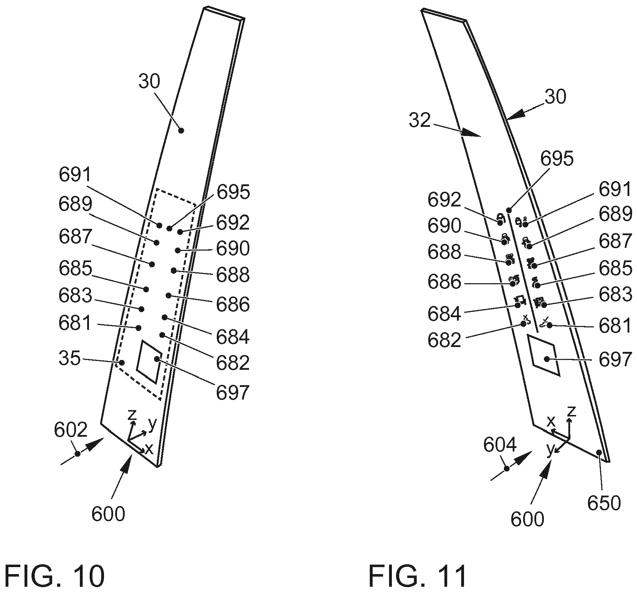

In Fig. 10 ist eine perspektivische Darstellung einer Blendeneinheit von der Betrachtungsseite dargestellt. Fig. 11 zeigt die entsprechende Rückseite der Blendeneinheit nach Fig. 10. Die Blendeneinheit erstreckt sich im Wesentlichen in einer x-z Ebene wie sich anhand eine Koordinatensystems 600 ergibt. Eine Betrachtung der Blendeneinheit 30 erfolgt in positiver y-Richtung 602. An der Rückseite 32 ist die Blendeneinheit, die ansonsten zumindest in einem Fensterbereich 35 für eine Durchleuchtung entlang der negativen y-Richtung 604 für sichtbares Licht transparent ist, mit einer opaken Beschichtung 650 versehen.

Eine Abschwächung des sichtbaren und oder infraroten Lichts kann in dem für die Durchleuchtung transparenten Material der Blendeneinheit stattfinden. Eine nennenswerte diffuse Streuung tritt jedoch nicht ein. Für infrarotes Licht ist das Material Blendeneinheit, gegebenenfalls bis auf die opake Beschichtung, vorzugsweise in beiden Richtungen 602, 604, transparent.

Gut zu erkennen sind die Informationselemente 681-692, die mittels Ausnehmungen in der opaken Beschichtung 650 ausgebildet sind. Eine Mittelausnehmung 695 ist dafür vorgesehen, das aus noch weiteren Aussparungen eines zu verbindenden Lichtleitmoduls austretende Licht durchzulassen.

Eine Sensorausnehmung 697 ist dafür vorgesehen, dass die infrarote Strahlung eines Gestenerkennungssensors möglichst wenig abgeschwächt durch die Blendeneinheit 30 transmittiert wird.

In Fig. 10 sind die Informationselemente 681-692, die Mittelausnehmung 695 und die Sensorausnehmung 697 zu erkennen, da hinter der Blendeneinheit ein heller Hintergrund bzw. eine Lichtquelle angenommen ist, so dass eine Durchleuchtung der Blendeneinheit 30 bzw. der opaken Beschichtung 650 an deren Rückseite 32 stattfindet.

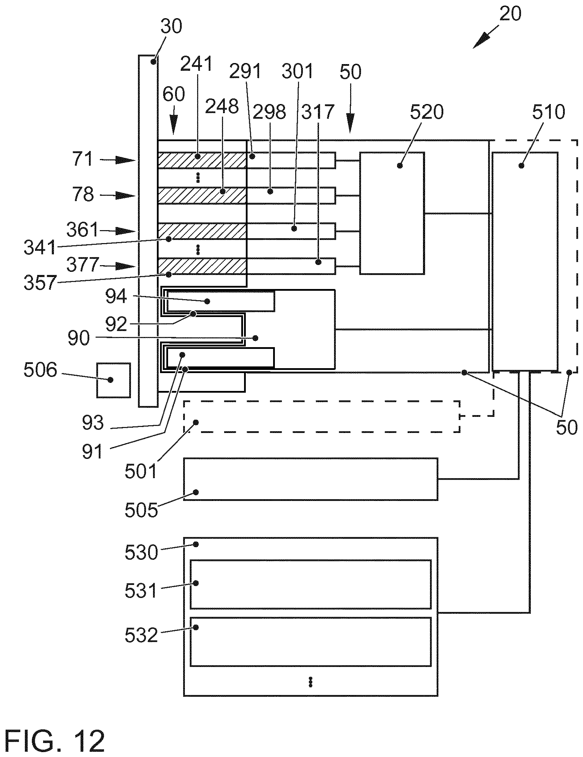

In Fig. 12 ist eine schematische Darstellung der Funktionskomponenten dargestellt, die bei einer Nutzung der Fahrzeugverkleidung 20 mit Anzeigefunktionalität und Gestensteuerung miteinander wechselwirken. Der Gestenerkennungssensor 90 wird in einem Grundbetrieb als Annäherungssensor verwendet. Alternativ kann ein anderer Annäherungssensor 501 genutzt werden, um die Annäherung eines Nutzers an die Fahrzeugverkleidung 20 zu erkennen. Wird die Annäherung eines Nutzers an die Fahrzeugverkleidung 20 erkannt, wird eine Authentifizierungseinheit 505 aktiviert, welche beispielsweise über eine drahtlose Kommunikation in einem sogenannten Challenge-Response-Verfahren das Vorhandensein eines Fahrzeugschlüssels 506 , der zu dem entsprechenden Fahrzeug gehört, in dem die Fahrzeugverkleidung 20 verbaut ist, prüft. Die Authentifizierung eines berechtigten Nutzers kann auch auf beliebige andere Art und Weise von der Authentifizierungseinrichtung 505 ausgeführt werden. Ist die Annäherung eines berechtigten, d.h. authentifizierten Nutzers an die Fahrzeugverkleidung 20 erkannt, so wird von einer Funktionssteuereinrichtung 510, die in dem Grundmodul 50 integriert sein kann oder getrennt von diesem Grundmodul 50 ausgebildet sein kann, die vollständige Aktivierung des Gestenerkennungssensors 90 und zusätzlich in der Regel eines der Leuchtmittel 291-298 angesteuert, um einem Nutzer eine Rückmeldung zu geben, dass über eine Geste eine Wechselwirkung mit der Fahrzeugverkleidung 20 bzw. dem Gestenerkennungssensor 90 möglich ist. Beispielsweise können die weiteren Hinterleuchtungsbereiche 361-371 einzeln oder gemeinsam aktiviert werden, wie dieses im Zusammenhang mit Fig. 3 bereits erwähnt wurde, die über noch weitere Lichtleitelemente 341-357 mit noch weiteren Leuchtmitteln 301-317 verbunden sind.
Über Gesten können mittels der Funktionssteuereinrichtung 510 Fahrzeugeinrichtungen 530, wie die Zentralverriegelung 531, eine Ladeeinrichtung 532 etc. bedient werden.

Um die möglichen Funktionalitäten, die das System bereitstellt und die über eine Geste bedient werden können, dem Nutzer zu vermitteln, werden bei einer Ausführungsform sämtliche Informationsbereiche beispielsweise in blauer Farbe hinterleuchtet bzw. für jede Funktionalität ein zugeordneter Informationsbereich hinterleuchtet, um die aktuelle Zustandsinformation des Systems an den Nutzer zu vermitteln. Wird über den Gestenerkennungssensor 90 eine Geste erfasst, beispielsweise eine Wischbewegung von links nach rechts über zwei benachbart angeordneten Informationsbereichen, die einer bestimmten Fahrzeugfunktionalität zugeordnet sind, so wird ein entsprechendes Fahrzeugsystem gemäß der erkannten Geste angesteuert und über die Funktionssteuereinrichtung 510 und/oder die Leuchtmittelsteuerung 520 die Leuchtmittel 291-297 so angesteuert, dass an den Nutzer eine entsprechende Rückmeldung der Funktionsaktivierung über ein Hinterleuchten der entsprechenden Informationselemente bzw. Symbolelemente in den entsprechenden Informationsbereichen vorgenommen wird. Beispielsweise kann eine Entriegelung des Fahrzeugs angezeigt werden oder durch den Nutzer ausgewählt werden, ob eine Aufladung des elektrischen Energiespeichers unmittelbar oder zeitverzögert erfolgen soll. Neben Wischgesten kann auch das Verdecken eines Informationsbereichs mit einem Betätigungselement, beispielsweise einer Hand, als Geste erfasst werden. Hier existieren vielfältige Ausgestaltungsmöglichkeiten.

Ist der Gestenerkennungssensor 90 beispielsweise als Teil der B-Säulenverkleidung in einer vorderen Fahrzeugtür 2 verbaut, so kann dieser auch eine Annäherung einer Hand an ein Türöffnungselement, beispielsweise einem Türgriff 12, erfassen, sodass weitere Sensorik, die eine Annäherung und/oder Betätigung eines Türgriffs erfasst, gegenüber Fahrzeugen aus dem Stand der Technik eingespart werden kann. Sensoren am Türgriff 12 können durch den Gestenerkennungssensor 90 ersetzt werden.

Entfernt sich der Nutzer aus dem Erfassungsbereich des Gestenerkennungssensors 90 oder wird der zur Authentifizierung verwendete Schlüssel aus dem Erfassungsbereich des Authentifizierungssensors entfernt, so wird die funktionelle Interaktion mit dem Nutzer beendet. Insbesondere aufgrund des Überprüfens, ob eine Person, die sich angenähert hat, authentifiziert ist, können alle oder einzelne Funktionalitäten, zu denen Informationsbereiche in der Fahrzeugverkleidung vorgesehen sind, deaktiviert werden.

Beispielsweise kann für ein Fahrzeug, welches im Carsharing betrieben wird, aber auch vorgesehen sein, dass eine Information, die angibt, ob ein Fahrzeug frei ist oder bereits durch einen anderen Nutzer reserviert ist, über eine Hinterleuchtung eines der entsprechenden Informationsbereiche dauerhaft oder bei Annäherung einer beliebigen Person ohne Überprüfung der Authentifizierung des Nutzers angezeigt wird. Eine Authentifizierung für die Nutzung weiterer Funktionen kann in diesem Fall beispielsweise über eine Kopplung mit einem Mobiltelefon und Abfrage von Authentifizierungsdaten über das Mobiltelefon vorgesehen sein, Nach einer erfolgreichen Authentifizierung sind die weiteren Funktionalitäten des Fahrzeugs durch den Nutzer über den Gestenerkennungssensor steuerbar.

### Bezugszeichenliste

- 1: Kraftfahrzeug
- 2: vordere Fahrzeugtür
- 3: hintere Fahrzeugtür
- 4: Heckklappe
- 5: A-Säule
- 6: B-Säule
- 7: C-Säule
- 8-10: Seitenfenster
- 12: Türgriff
- 20: Fahrzeugverkleidung mit Anzeigefunktionalität
- 21: Längsrichtung
- 30: Blendeneinheit
- 31: Betrachtungsseite
- 32: Rückseite
- 35: Fensterbereich
- 40: Funktionseinheit
- 45: Eingabeeinheit
- 46: Steckkontakte
- 47: Anschlusskontakte
- 50: Grundmodul
- 51: Vorderseite
- 52: Rückseite
- 53: Seitenwand
- 54: gegenüberliegende Seitenwand
- 55: Oberseite
- 56: Unterseite
- 57: kleiner zylindrischer Vorsprung
- 58: großer zylindrischer Vorsprung
- 59: Gehäuse
- 60: Lichtleitmodul
- 61: Vorderseite
- 62: Rückseite
- 71-78: Informationsbereiche
- 81-88: Informations-/Symbolelemente
- 90: Gestenerkennungssensor
- 91: Sensorelemente
- 92: Sensorelemente
- 93: Infrarotsender
- 94: Infrarotempfangssensor
- 101,102: Funktionsaussparungen
- 111-118: Aussparungen
- 151-158: Lichtaustrittsbereiche
- 161-164: weitere Lichtaustrittsbereiche
- 201: Steckverbinder
- 205: Steckkontakte
- 211: Luftaustauschelement
- 233-238: Lichteinkoppelbereiche
- 243-248: Lichtleitelemente
- 250: opake Stege
- 252: Bereich (in dem Informationselemente ausgebildet sind)
- 271-284: Informationsbereiche
- 291-298: Leuchtmittel
- 301-317: noch weitere Leuchtmittel
- 341-357: weitere Lichtleitelemente
- 361-377: weitere Hinterleuchtungsbereiche
- 501: anderer Annäherungssensor
- 505: Authentifizierungseinheit
- 506: Fahrzeugschlüssel
- 510: Funktionssteuereinrichtung
- 520: Leuchtmittelsteuerung
- 530: Fahrzeugeinrichtungen
- 531: Zentralverriegelung
- 532: Ladeeinrichtung
- 600: Koordinatensystem
- 602: positive y-Richtung
- 604: negative y-Richtung
- 650: opake Beschichtung
- 681-692: Informationselemente (Symbolelemente)
- 695: Mittelausnehmung
- 697: Sensorausnehmung

## Patentansprüche

1. Fahrzeugverkleidung (20) mit Anzeigefunktionalität umfassend:
eine Blendeneinheit (30) mit mindestens einem im sichtbaren Wellenlängenbereich für eine Durchleuchtung zumindest bereichsweise transparenten Fensterbereich (35);
sowie eine Funktionseinheit (40) mit mindestens einem Leuchtmittel (298) oder mit mindestens einem Leuchtmittel (298) und einer Eingabeeinheit (45),
wobei die Funktionseinheit (40) als Grundmodul (50) mit einem in sich abgeschlossenen wasserdichten Gehäuse (59) ausgebildet ist, in dessen Inneren das mindestens eine Leuchtmittel (298) und, sofern die Eingabeeinheit (45) vorhanden ist, die Eingabeeinheit (45) angeordnet sind, wobei das Grundmodul (50) mit der Blendeneinheit (30) mechanisch verbunden ist,
**dadurch gekennzeichnet, dass**
zwischen der Blendeneinheit (30) und dem Grundmodul (50) ein Lichtleitmodul (60) angeordnet ist, wobei das Lichtleitmodul (60) mindestens eine Aussparung (118) zum Ausbilden eines hinterleuchtbaren Informationsbereichs (78) aufweist, wobei die mindestens eine Aussparung (118) von dem zumindest bereichsweise transparenten Fensterbereich (35) der Blendeneinheit (30) überdeckt ist..

2. Fahrzeugverkleidung (20) nach Anspruch 1, **dadurch gekennzeichnet, dass** das Grundmodul (50) und das Lichtleitmodul (60) und/oder die Blendeneinheit (30) Kopplungsmittel umfassen, sodass das Grundmodul (50) an dem Lichtleitmodul (60) und/oder der Blendeneinheit (30) mittels einer Rastverbindung befestigt ist.

3. Fahrzeugverkleidung (20) nach einem der Ansprüche 1 oder 2, **dadurch gekennzeichnet, dass** das Grundmodul (50) mindestens einen Lichtaustrittsbereich (158) aufweist, aus dem das Licht des mindestens einen Leuchtmittels (298) aus dem Grundmodul (50) austritt, und das Grundmodul (50) so an dem Lichtleitmodul (60) angeordnet ist, dass sich der mindestens eine Lichtaustrittsbereich (158) nicht mit der mindestens einen Aussparung (118) überlappt, die den mindestens einen Informationsbereich (78) für eine Hinterleuchtung ausbildet, und in dem Lichtleitmodul (60) mindestens ein Lichtleitelement (248) ausgebildet ist, welches das aus dem mindestens einen Lichtaustrittsbereich (158) des Grundmoduls (50) austretende Licht zu dem hinterleuchtbaren mindestens einen Informationsbereich (78) der mindestens einen Aussparung (118) leitet.

4. Fahrzeugverkleidung (20) nach einem der Ansprüche 1 bis 3, **dadurch gekennzeichnet, dass** das Lichtleitmodul (60) zusätzlich zu der den mindestens einen Informationsbereich (78) ausbildenden mindestens einen Aussparung (118) weitere Aussparungen (113-117) aufweist, die weitere Informationsbereiche (73-77) für eine Hinterleuchtung ausbilden, das Grundmodul (50) weitere Lichtaustrittsbereiche (153-157) aufweist, denen jeweils ein individuell ansteuerbares Leuchtmittel (293-297) zugeordnet ist, und in dem Lichtleitmodul (60) weitere voneinander und dem mindestens einen Lichtleitelement (248) optisch isolierte Lichtleitelemente (243-247) ausgebildet sind, um jeweils das aus einem der weiteren Lichtaustrittsbereiche (153-157) austretende Licht zu einem der weiteren Informationsbereiche (73-77) zu leiten.

5. Fahrzeugverkleidung (20) nach einem der Ansprüche 1 bis 4, **dadurch gekennzeichnet, dass** das Grundmodul (50) mindestens ein zusätzliches individuell ansteuerbares Leuchtmittel (291, 292) umfasst, dessen Licht aus einem zusätzlichen Lichtaustrittsbereich (151, 152) bei einer Ansteuerung austritt, und das Lichtleitmodul (60) mindestens eine zusätzliche Aussparung (111, 112) zum Ausbilden mindestens eines zusätzlichen Informationsbereichs (71, 72) aufweist, wobei sich die mindestens eine zusätzliche Aussparung (111, 82) und der mindestens einen zusätzliche Lichtaustrittsbereich (151, 152) überlappen, sodass das aus dem mindestens einen zusätzlichen Lichtaustrittsbereich (151, 152) austretende Licht den mindestens einen zusätzlichen Informationsbereich (71, 72) unmittelbar hinterleuchtet.

6. Fahrzeugverkleidung (20) nach einem der vorangegangenen Ansprüche, **dadurch gekennzeichnet, dass** die Eingabeeinheit (45) einen berührungslos arbeitenden Gestenerkennungssensor (90) umfasst.

7. Fahrzeugverkleidung (20) nach einem der Ansprüche 3 bis 6, **dadurch gekennzeichnet, dass** die mindestens eine Aussparung (118) und/oder die weiteren Aussparungen (113-117) sowie das mindestens eine Lichtleitelement (248) und die weiteren Lichtleitelemente (243-247) an einer von der Blendeneinheit (30) abgewandten Seite jeweils von opakem, vorzugsweise Licht absorbierendem, bevorzugter dunkel eingefärbten, besonders bevorzugt schwarzem Material abgedeckt sind.

8. Fahrzeugverkleidung (20) nach einem der Ansprüche 1 bis 7, **dadurch gekennzeichnet, dass** das Lichtleitmodul (60) Aussparungen umfasst, um Sensorelemente (91, 92) der Eingabeeinheit (45) aufzunehmen.

9. Fahrzeugverkleidung (20) nach Anspruch 8, **dadurch gekennzeichnet, dass** die Blendeneinheit (30) eine geschlossene Oberfläche aufweist und zumindest in dem in einem Abschnitt des zumindest bereichsweise transparenten Fensterbereichs (35), der die Sensorelemente (91, 92) der Eingabeeinheit (45) überdeckt, transparent für Strahlung im nicht sichtbaren Wellenlängenbereich ist, welche von den Sensorelementen (91, 92) der Eingabeeinheit (45) ausgesandt und/oder empfangen wird.

## Claims

1. Vehicle cladding (20) with display functionality, comprising:
a panel unit (30) having at least one window region (35) that is transparent to transillumination in the visible wavelength range at least in regions;
and a functional unit (40) having at least one lighting means (298) or having at least one lighting means (298) and one input unit (45),
wherein the functional unit (40) is configured as a base module (50) having a sealed waterproof housing (59), in the interior of which the at least one lighting means (298) and, if the input unit (45) is present, the input unit (45) are arranged, wherein the base module (50) is mechanically connected to the panel unit (30),
**characterized in that**
an optical waveguide module (60) is arranged between the panel unit (30) and the base module (50), wherein the optical waveguide module (60) has at least one recess (118) for forming an information field (78) that can be backlit, wherein the at least one recess (118) is covered by the window region (35), which is transparent at least in regions, of the panel unit (30).

2. Vehicle cladding (20) according to claim 1, **characterized in that** the base module (50) and the optical waveguide module (60) and/or the panel unit (30) comprise coupling means such that the base module (50) is fastened to the optical waveguide module (60) and/or the panel unit (30) by means of a latching connection.

3. Vehicle cladding (20) according to either of claims 1 or 2, **characterized in that** the base module (50) has at least one light exit region (158) out of which the light of the at least one lighting element (298) exits from the basic module (50), and the base module (50) is arranged on the optical waveguide module (60) such that the at least one light exit region (158) does not overlap with the at least one recess (118) which forms the at least one information field (78) for backlighting, and at least one optical waveguide element (248) is formed in the optical waveguide module (60) which guides the light exiting out of the at least one light exit region (158) of the base module (50) to the at least one information field (78), which is able to be backlit, of the at least one recess (118).

4. Vehicle cladding (20) according to any one of claims 1 to 3, **characterized in that,** in addition to the at least one recess (118) forming the at least one information field (78), the optical waveguide module (60) has further recesses (113-117) which form further information fields (73-77) for backlighting, the base module (50) has further light exit regions (153-157), each of which is associated with an individually activatable lighting means (293-297), and further optical waveguide elements (243-247), which are optically isolated from each other and from the at least one optical waveguide element (248), are formed in the optical waveguide module (60) in order to guide in each case the light emerging from one of the further light exit regions (153-157) to one of the further information fields (73-77).

5. Vehicle cladding (20) according to any one of claims 1 to 4, **characterized in that** the base module (50) comprises at least one additional individually lighting means (291, 292) that can be activated, the light of which emerges from an additional light exit region (151, 152) when activated, and the optical waveguide module (60) has at least one additional recess (111, 112) for forming an additional information field (71, 72), wherein the at least one additional recess (111, 82) and the at least one additional light exit region (151, 152) overlap such that the light emerging from the at least one additional light exit region (151, 152) directly backlights the at least one additional information field (71, 72).

6. Vehicle cladding (20) according to any one of the preceding claims, **characterized in that** the input unit (45) comprises a contactless gesture recognition sensor (90).

7. Vehicle cladding (20) according to any one of claims 3 to 6, **characterized in that** the at least one recess (118) and/or the further recesses (113-117) and also the at least one optical waveguide element (248) and the further optical waveguide elements (243-247) are each covered by opaque, preferably light-absorbing, preferably dark-colored, particularly preferably black material on a side facing away from the panel unit (30).

8. Vehicle cladding (20) according to any one of claims 1 to 7, **characterized in that** the optical waveguide module (60) comprises recesses for receiving sensor elements (91, 92) of the input unit (45).

9. Vehicle cladding (20) according to claim 8, **characterized in that** the panel unit (30) has a closed surface and is transparent to radiation in the non-visible wavelength range which is emitted and/or received by the sensor elements (91, 92) of the input unit (45), at least in one section of the window region (35) of which at least some regions are transparent and which covers the sensor elements (91, 92) of the input unit (45).

## Revendications

1. Habillage de véhicule (20) comprenant un fonction d'affichage, comprenant :
une unité cache (30) comprenant au moins une zone de fenêtre (35) au moins partiellement transparente pour un éclairage dans une plage de longueurs d'onde visibles ;
ainsi qu'une unité fonctionnelle (40) comprenant au moins une source lumineuse (298) ou comprenant au moins une unité lumineuse (298) et une unité d'entrée (45),
l'unité fonctionnelle (40) étant conçue comme un module de base (50) comprenant un boîtier (59) étanche à l'eau fermé en lui-même, à l'intérieur duquel ladite au moins une source lumineuse (298) et, si l'unité d'entrée (45) est présente, l'unité d'entrée (45) est/sont disposées, le module de base (50) étant relié mécaniquement à l'unité cache (30),
**caractérisé en ce que**
un module guide de lumière (60) est disposé entre l'unité cache (30) et le module de base (50), le module guide de lumière (60) présentant au moins un évidement (118) pour la formation d'une zone d'informations (78) pouvant être rétro-éclairée, ledit au moins un évidement (118) étant recouvert par la zone de fenêtre (35) au moins partiellement transparente de l'unité cache (30).

2. Habillage de véhicule (20) selon la revendication 1, **caractérisé en ce que** le module de base (50) et le module guide de lumière (60) et/ou l'unité cache (30) comprennent des moyens d'accouplement, de telle sorte que le module de base (50) est fixé au module guide de lumière (60) et/ou à l'unité cache (30) au moyen d'une liaison d'encliquetage.

3. Habillage de véhicule (20) selon l'une quelconque des revendications 1 ou 2, **caractérisé en ce que** le module de base (50) présente au moins une zone de sortie de lumière (158), via laquelle la lumière de ladite au moins une source lumineuse (298) sort du module de base (50), et le module de base (50) est disposé de telle façon sur le module guide de lumière (60) que ladite au moins une zone de sortie de lumière (158) ne chevauche pas ledit au moins un évidement (118), qui forme ladite au moins une zone d'informations (78) pour un rétro-éclairage, et au moins un élément guide de lumière (248) est formé dans le module guide de lumière (60), lequel guide la lumière sortant via ladite au moins une zone de sortie de lumière (158) du module de base (50) vers ladite au moins une zone d'informations (78) pouvant être rétro-éclairée dudit au moins un évidement (118).

4. Habillage de véhicule (20) selon l'une quelconque des revendications 1 à 3, **caractérisé en ce que** le module guide de lumière (60) présente, outre ledit au moins un évidement (118) formant ladite au moins une zone d'informations (78), d'autres évidements (113-117) qui forment d'autres zones d'informations (73-77) pour un rétro-éclairage, le module de base (50) présente d'autres zones de sortie de lumière (153-157), auxquelles une source lumineuse (293-297) pouvant être commandée individuellement est respectivement associée, et d'autres éléments guides de lumière (243-247) isolés optiquement les uns des autres et dudit au moins un élément guide de lumière (248) sont formés dans le module guide de lumière (60), pour guider respectivement la lumière sortant via l'une des autres zones de sortie de lumière (153-157) vers une des autres zones d'informations (73-77).

5. Habillage de véhicule (20) selon l'une quelconque des revendications 1 à 4, **caractérisé en ce que** le module de base (50) comprend au moins une source lumineuse (291, 292) supplémentaire pouvant être commandée individuellement, dont la lumière sort, en cas de commande, via une zone de sortie de lumière (151, 152) supplémentaire, et le module guide de lumière (60) présente au moins un évidement (111, 112) supplémentaire pour la formation d'au moins une zone d'informations (71, 72) supplémentaire, ledit au moins un évidement supplémentaire (111, 82) et ladite au moins une zone de sortie de lumière (151, 152) supplémentaire se chevauchant de telle sorte que la lumière sortant via ladite au moins une zone de sortie de lumière (151, 152) supplémentaire rétro-éclaire directement ladite au moins une zone d'informations (71, 72) supplémentaire.

6. Habillage de véhicule (20) selon l'une quelconque des revendications précédentes, **caractérisé en ce que** l'unité d'entrée (45) comprend un capteur de reconnaissance de gestes (90) fonctionnant sans contact.

7. Habillage de véhicule (20) selon l'une quelconque des revendications 3 à 6, **caractérisé en ce que** ledit au moins un évidement (118) et/ou les autres évidements (113-117) ainsi que ledit au moins un élément guide de lumière (248) et les autres éléments guides de lumière (243-247) sont respectivement recouverts, sur un côté opposé à l'unité cache (30), par un matériau opaque, de préférence absorbant la lumière, plus préférablement de couleur foncée, encore plus préférablement noir.

8. Habillage de véhicule (20) selon l'une quelconque des revendications 1 à 7, **caractérisé en ce que** le module guide de lumière (60) comprend des évidements pour la réception d'éléments capteurs (91, 92) de l'unité d'entrée (45).

9. Habillage de véhicule (20) selon la revendication 8, **caractérisé en ce que** l'unité cache-lumière (30) présente une surface fermée et est, au moins dans une section de la zone de fenêtre (35) au moins partiellement transparente qui recouvre les éléments capteurs (91, 92) de l'unité d'entrée (45), transparente pour un rayonnement dans une plage de longueurs d'onde non visibles, lequel est émis et/ou reçu par les éléments capteurs (91, 92) de l'unité d'entrée (45).
